# EUROPÄISCHE PATENTANMELDUNG

(11) **EP 3 667 929 A2**
(43) Veröffentlichungstag der Anmeldung: **17.06.2020**
(21) Anmeldenummer: 19210009.7
(22) Anmeldetag: 19.11.2019
(51) Int. Cl.: H04B 1/04, H03L 7/00, H03L 1/00, H04W 56/00, H04L 7/00

(54) **NEUTRALISIERUNG VON UMWELTEINFLÜSSEN AUF DIE SENDEPARAMETER**

(30) Priorität: 23.11.2018 DE 102018220202
(71) Anmelder: FRAUNHOFER-GESELLSCHAFT zur Förderung der angewandten Forschung e.V., 80686 München (DE); Diehl Metering GmbH, 91522 Ansbach (DE)
(72) Erfinder: Kilian, Gerd, 91058 Erlangen (DE); Bernhard, Josef, 91058 Erlangen (DE); Wechsler, Johannes, 91058 Erlangen (DE); Kneißl, Jakob, 91058 Erlangen (DE); Soller, Dominik, 91058 Erlangen (DE); Schlicht, Michael, 91058 Erlangen (DE); Kauppert, Thomas, 90455 Nürnberg (DE); Petkov, Hristo, 90425 Nürnberg (DE); Mzyk, Raphael, 91126 Kammerstein (DE); Gottschalk, Klaus, 90610 Winkelhaid (DE)
(74) Vertreter: Schlenker, Julian

(57) **Zusammenfassung**

Ausführungsbeispiele schaffen einen Datensender mit einer Sendeeinrichtung, die ausgebildet ist, um ein Signal zu senden, wobei zumindest ein Signalparameter des Signals von einem Umweltparameter in einer Umgebung des Datensenders abhängig ist, und einer Abschirmeinrichtung, die ausgebildet ist, um die Sendeeinrichtung oder einen Teil der Sendeeinrichtung von dem Umweltparameter abzuschirmen, um eine empfängerseitige, rekonstruierbare Auswirkung des Umweltparameters auf den zumindest einen Signalparameter zu reduzieren, und/oder einer Einrichtung zum Modifizieren des Signalparameters, die ausgebildet ist, um den zumindest einen Signalparameter zu modifizieren, um eine empfängerseitige, rekonstruierbare Auswirkung des Umweltparameters auf den zumindest einen Signalparameter zu reduzieren, wobei die Einrichtung zum Modifizieren des Signalparameters ausgebildet ist, um den zumindest einen Signalparameter direkt oder ein von einem Taktsignal eines Taktgebers des Datensenders abgeleitetes Signal, von dem das Signal oder eine Erzeugung des Signals abhängig ist, zu modifizieren, um den zumindest einen Signalparameter zu modifizieren.

## Beschreibung

Ausführungsbeispiele der vorliegenden Erfindung beziehen auf einen Datensender, einen Datenempfänger sowie ein Kommunikationssystem mit einem Datensender und einem Datenempfänger, und im speziellen, auf eine Reduzierung von Umwelteinflüssen (Umweltparametern) auf im Kommunikationssystem übertragene Signale.

Herkömmlicherweise kommen in Funksystemen zur Erzeugung von Signalen Taktgeber, wie z.B. Oszillatoren, zum Einsatz. Von den Taktgebern bereitgestellte Taktsignale und somit auch die von den Taktsignalen abgeleiteten Sendesignale sind jedoch von den Umgebungsbedingungen (Umweltparameter), insbesondere einer Temperatur, in den jeweiligen Umgebungen der Datensender abhängig.

Durch Auswertung von Signalparametern der empfangenen Signale ist es somit möglich Rückschlüsse auf die Umgebungsbedingungen der jeweiligen Datensender zu schließen.

Der vorliegenden Erfindung liegt die Aufgabe zugrunde, die bestehende Situation zu verbessern.

Diese Aufgabe wird durch die unabhängigen Patentansprüche gelöst.

Vorteilhafte Weiterbildungen finden sich in den abhängigen Patentansprüchen.

Ausführungsbeispiele schaffen einen Datensender mit einer Sendeeinrichtung, die ausgebildet ist, um ein Signal zu senden, wobei zumindest ein Signalparameter des Signals von einem Umweltparameter in einer Umgebung des Datensenders abhängig ist, und einer Abschirmeinrichtung, die ausgebildet ist, um die Sendeeinrichtung oder einen Teil der Sendeeinrichtung von dem Umweltparameter abzuschirmen, um eine empfängerseitige, rekonstruierbare Auswirkung des Umweltparameters auf den zumindest einen Signalparameter zu reduzieren [z.B. um eine empfängerseitige Schätzung des Umweltparameters basierend auf dem zumindest einen Signalparameter zu erschweren].

Bei Ausführungsbeispielen kann die Sendeeinrichtung einen Taktgeber aufweisen, wobei ein von dem Taktgeber bereitgestelltes Taktsignal [z.B. ein Taktsignalparameter [z.B. Taktfrequenz] des Taktsignals] von dem Umweltparameter in der Umgebung des Datensenders abhängig ist, wobei das Signal oder eine Erzeugung des Signals von dem Taktsignal des Taktgebers abhängig ist, wobei die Abschirmeinrichtung ausgebildet ist, um die Sendeeinrichtung oder den Taktgeber der Sendeeinrichtung von dem Umweltparameter abzuschirmen [z.B. um einen Einfluss des Umweltparameters auf einen Taktsignalparameter des Taktsignals zu reduzieren].

Bei Ausführungsbeispielen kann der Umweltparameter eine Umgebungstemperatur sein, wobei die Abschirmeinrichtung ausgebildet ist, um die Sendeeinrichtung von der Umgebungstemperatur thermisch abzuschirmen.

Bei Ausführungsbeispielen kann der Umweltparameter eine Umgebungstemperatur sein, wobei die Abschirmeinrichtung ausgebildet ist, um eine thermische Trägheit zwischen der Umgebungstemperatur und der Sendeeinrichtung zu erhöhen [z.B. um eine thermische Trägheit zwischen der Umgebungstemperatur und einer Auswirkung der Umgebungstemperatur auf den Signalparameter zu erhöhen].

Bei Ausführungsbeispielen kann die Abschirmeinrichtung einen Kühlkörper aufweisen, der mit der Sendeeinrichtung thermisch gekoppelt ist [z.B. um eine thermische Stabilität und/oder Trägheit zu erhöhen].

Bei Ausführungsbeispielen kann die Abschirmeinrichtung ausgebildet sein, um die Sendeeinrichtung zu kühlen.

Beispielsweise kann die Abschirmeinrichtung einen Kühlkörper aufweisen, der ausgebildet ist, um die Sendeeinrichtung zu kühlen, z.B. um eine thermische Stabilität und/oder Trägheit zu erhöhen.

Bei Ausführungsbeispielen kann die Abschirmeinrichtung ausgebildet sein, um die Sendeeinrichtung zu heizen.

Beispielsweise kann die Abschirmeinrichtung ein Heizelement aufweisen, das ausgebildet ist, um die Sendeeinrichtung zu heizen, z.B. um eine thermische Stabilität und/oder Trägheit zu erhöhen.

Bei Ausführungsbeispielen kann die Abschirmeinrichtung ausgebildet sein, um die Sendeeinrichtung oder einen Taktgeber der Sendeeinrichtung mit einem Microcontroller des Datensenders thermisch zu koppeln, um eine Temperatur der Sendeeinrichtung oder des Taktgebers zu beeinflussen.

Beispielsweise können auf dem Microcontroller rechenintensive Rechenschritte ausgeführt werden, um die Temperatur der Sendeeinrichtung zu erhöhen.

Bei Ausführungsbeispielen kann der Datensender ausgebildet sein, um den Mikrocontroller zu zufälligen oder pseudo-zufälligen Zeitpunkten zu aktivieren, um eine Temperatur der Sendeeinrichtung oder des Taktgebers zu beeinflussen.

Bei Ausführungsbeispielen kann der Datensender ausgebildet sein, um den Mikrocontroller für eine zufällige oder pseudo-zufällige Zeit aktiviert zu lassen, um eine Temperatur der Sendeeinrichtung oder des Taktgebers zu beeinflussen.

Bei Ausführungsbeispielen kann die Abschirmeinrichtung ausgebildet sein, um den Einfluss des Umweltparameters auf den Signalparameter um zumindest den Faktor 5 [z.B. oder 10] zu reduzieren.

Bei Ausführungsbeispielen kann der Signalparameter des Signals
- eine Trägerfrequenz,
- ein Sendezeitpunkt,
- eine Symbolrate,
- ein Modulationsindex, oder
- eine Signalleistung
   oder eine Änderung derselben bzw. desselben sein.

Bei Ausführungsbeispielen kann der Umweltparameter
- eine Temperatur,
- eine Luftfeuchtigkeit,
- ein Atmosphärendruck,
- eine elektromagnetische Strahlung,
- eine Helligkeit,
- eine Bewegung und/oder
- eine Vibration
oder eine Änderung derselben bzw. desselben sein.

Bei Ausführungsbeispielen kann der Datensender eine Einrichtung zum Modifizieren des Signalparameters aufweisen, die ausgebildet ist, um den zumindest einen Signalparameter zu modifizieren, um eine empfängerseitige, rekonstruierbare Auswirkung des Umweltparameters auf den zumindest einen Signalparameter zu reduzieren [z.B. um eine empfängerseitige Schätzung des Umweltparameters basierend auf dem zumindest einen Signalparameter zu erschweren], wobei die Einrichtung zum Modifizieren des Signalparameters ausgebildet ist, um den zumindest einen Signalparameter direkt oder ein von einem Taktsignal eines Taktgebers des Datensenders abgeleitetes Signal, von dem das Signal oder eine Erzeugung des Signals abhängig ist, zu modifizieren, um den zumindest einen Signalparameter zu modifizieren.

Weitere Ausführungsbeispiele schaffen einen Datensender, wobei der Datensender eine Sendeeinrichtung aufweist, die ausgebildet ist, um ein Signal zu senden, wobei zumindest ein Signalparameter des Signals von einem Umweltparameter in einer Umgebung des Datensenders abhängig ist, wobei der Datensender eine Einrichtung zum Modifizieren des Signalparameters aufweist, die ausgebildet ist, um den zumindest einen Signalparameter zu modifizieren, um eine empfängerseitige, rekonstruierbare Auswirkung des Umweltparameters auf den zumindest einen Signalparameter zu reduzieren [z.B. um eine empfängerseitige Schätzung des Umweltparameters basierend auf dem zumindest einen Signalparameter zu erschweren], wobei die Einrichtung zum Modifizieren des Signalparameters ausgebildet ist, um den zumindest einen Signalparameter direkt oder ein von einem Taktsignal eines Taktgebers des Datensenders abgeleitetes Signal, von dem das Signal oder eine Erzeugung des Signals abhängig ist, zu modifizieren, um den Signalparameter zu modifizieren.

Bei Ausführungsbeispielen kann die Einrichtung zum Modifizieren des Signalparameters ausgebildet sein, um den Signalparameter basierend auf einer Abweichung des Signalparameters von einem Sollwert zu modifizieren.

Bei Ausführungsbeispielen kann ein von dem Taktgeber bereitgestelltes Taktsignal von dem Umweltparameter in der Umgebung des Datensenders abhängig sein, wobei das Signal oder eine Erzeugung des Signals von dem Taktsignal des Taktgebers abhängig ist.

Bei Ausführungsbeispielen kann die Einrichtung zum Modifizieren des Signalparameters ausgebildet sein, um eine Abweichung eines Taktsignalparameters [z.B. Frequenz] des Taktsignals von einem Sollwert [z.B. Sollfrequenz] zu ermitteln, wobei die Einrichtung zum Modifizieren des Signalparameters ausgebildet ist, um den Signalparameter des Signals basierend auf der ermittelten Abweichung des Taktsignalparameters zu modifizieren.

Bei Ausführungsbeispielen kann die Einrichtung zum Modifizieren des Signalparameters ausgebildet sein, um den Signalparameter des Signals in Abhängigkeit von dem Umweltparameter in der Umgebung des Datensenders zu modifizieren.

Bei Ausführungsbeispielen kann der Datensender ausgebildet sein, um den Umweltparameter in der Umgebung des Datensenders zu ermitteln.

Beispielsweise kann der Datensender einen Sensor für den Umweltparameter aufweisen.

Bei Ausführungsbeispielen kann der Datensender ausgebildet sein, um ein Signal von einem anderen Datensender zu empfangen, wobei das empfangene Signal eine Information über den Umweltparameter in der Umgebung des Datensenders aufweist oder wobei der Datensender ausgebildet ist, um basierend auf einem Signalparameter des empfangenen Signals den Umweltparameter in der Umgebung des Datensenders zu schätzen.

Bei Ausführungsbeispielen kann die Einrichtung zum Modifizieren des Signalparameters ausgebildet sein, um einen Taktteiler des Taktsignals, der zur Erzeugung des Signals verwendet wird, basierend auf dem Umweltparameter in der Umgebung des Datensenders zu verändern, um den Signalparameter des Signals zu modifizieren, wobei der Taktteiler kein Teil des Taktgebers ist.

Bei Ausführungsbeispielen kann die Einrichtung zum Modifizieren des Signalparameters ausgebildet sein, um einen einstellbaren Kondensator, der zur Erzeugung des Signals verwendet wird, basierend auf dem Umweltparameter in der Umgebung des Datensenders einzustellen, um den Signalparameter des Signals zu modifizieren, wobei der Kondensator kein Teil des Taktgebers ist.

Bei Ausführungsbeispielen kann die Einrichtung zum Modifizieren des Signalparameters ausgebildet sein, um Korrekturwerte für den Signalparameter an die Sendeeinrichtung auszugeben, um den Signalparameter des Signals zu modifizieren.

Bei Ausführungsbeispielen kann der Signalparameter des Signals
- eine Trägerfrequenz,
- ein Sendezeitpunkt,
- eine Symbolrate,
- ein Modulationsindex, oder
- eine Signalleistung
   oder eine Änderung derselben bzw. desselben sein.

Bei Ausführungsbeispielen kann der Umweltparameter
- eine Temperatur,
- eine Luftfeuchtigkeit,
- ein Atmosphärendruck,
- eine elektromagnetische Strahlung,
- eine Helligkeit,
- eine Bewegung und/oder
- eine Vibration
oder eine Änderung derselben bzw. desselben sein.

Bei Ausführungsbeispielen kann der Datenempfänger ausgebildet ist, um ein Signal eines Datensenders zu empfangen, wobei das Signal oder eine Erzeugung des Signals von einem Taktsignal eines Taktgebers des Datensenders abhängig ist, wobei der Datenempfänger ausgebildet ist, um einen Signalparameter des Signals zu ermitteln, und um basierend auf dem Signalparameter einen Umweltparameter zu ermitteln, dem der Taktgeber des Datensenders oder das Signal ausgesetzt ist, wobei der Datensender ausgebildet ist, um eine datensenderseitige Modifizierung des Signalparameters vor der Schätzung des Signalparameters oder des Umweltparameters zu kompensieren.

Bei Ausführungsbeispielen kann dem Datenempfänger die datensenderseitige Modifizierung des Signalparameters [z.B. der Offset, mit dem der Signalparameter datensenderseitig beaufschlagt ist] bekannt sein.

Bei Ausführungsbeispielen kann der Datenempfänger ausgebildet sein, um die datensenderseitige Modifizierung des Signalparameters [z.B. der Offset, mit dem der Signalparameter datensenderseitig beaufschlagt ist] von einem immanenten Parameter des Kommunikationssystems des Datenempfängers oder einer mit dem Signal übertragenen Nachricht abzuleiten.

Bei Ausführungsbeispielen kann der Datenempfänger ausgebildet sein, um die datensenderseitige Modifizierung des Signalparameters [z.B. der Offset, mit dem der Signalparameter datensenderseitig beaufschlagt ist] von einem dem Datensender und dem Datenempfänger bekannten kryptografischen Schlüssel oder Schlüsselpaar abzuleiten.

Weitere Ausführungsbeispiele schaffen ein System mit einem Datensender gem. einem der hierin beschriebenen Ausführungsbeispiele und einem Datenempfänger Datensender gem. einem der hierin beschriebenen Ausführungsbeispiele.

Weitere Ausführungsbeispiele schaffen ein Verfahren. Das Verfahren umfasst einen Schritt des Sendens eines Signals mit einer Sendeeinrichtung des Datensenders, wobei zumindest ein Signalparameter des Signals von einem Umweltparameter in einer Umgebung des Datensenders abhängig ist. Ferner umfasst das Verfahren einen Schritt des Abschirmens der Sendeeinrichtung oder einen Teil der Sendeeinrichtung von dem Umweltparameter, um eine empfängerseitige, rekonstruierbare Auswirkung des Umweltparameters auf den zumindest einen Signalparameter zu reduzieren [z.B. um eine empfängerseitige Schätzung des Umweltparameters basierend auf dem zumindest einen Signalparameter zu erschweren].

Weitere Ausführungsbeispiele schaffen ein Verfahren. Das Verfahren umfasst einen Schritt des Erzeugens eines Sendesignals, wobei zumindest ein Signalparameter des Sendesignals von einem Umweltparameter in einer Umgebung des Datensenders abhängig ist, wobei bei dem Erzeugen des Sendesignals der zumindest eine Signalparameter modifiziert wird, um eine empfängerseitige, rekonstruierbare Auswirkung des Umweltparameters auf den zumindest einen Signalparameter zu reduzieren [z.B. um eine empfängerseitige Schätzung des Umweltparameters basierend auf dem zumindest einen Signalparameter zu erschweren], wobei der Signalparameter direkt oder ein von einem Taktsignal eines Taktgebers des Datensenders abgeleitetes Signal, von dem das Signal oder eine Erzeugung des Signals abhängig ist, modifiziert wird, um den Signalparameter zu modifizieren. Das Verfahren umfasst ferner einen Schritt des Sendens des Sendesignals.

Weitere Ausführungsbeispiele schaffen ein Verfahren. Das Verfahren umfasst einen Schritt des Empfangens eines Signals eines Datensenders, wobei das Signal oder eine Erzeugung des Signals von einem Taktsignal eines Taktgebers des Datensenders abhängig ist. Das Verfahren umfasst ferner einen Schritt des Ermittelns eines Signalparameters des empfangenen Signals. Das Verfahren umfasst ferner einen Schritt des Ermittelns eines Umweltparameters, dem der Taktgeber des Datensenders oder das Signal ausgesetzt ist, basierend auf dem ermittelten Signalparameter. Das Verfahren umfasst ferner einen Schritt des Kompensierens einer datensenderseitigen Modifizierung des Signalparameters vor der Ermittlung des Signalparameters oder des Umweltparameters.

Der vorliegenden Erfindung liegt die Idee zugrunde, Umgebungsbedingungen (z.B. Umweltparameter) in einer Umgebung eines Datensenders, die bedingt durch ihren Einfluss auf die Eigenschaften eines übertragenen Signals zu einem Datenempfängern mitübertragen werden, zu verschleiern [z.B. um eine empfängerseitige Schätzung der Umgebungsbedingungen (z.B. eines oder mehreren Umweltparameter) durch Auswertung der Signaleigenschaften (z.B. eines oder mehrerer Signalparameter) zu erschweren].

Bei Ausführungsbeispielen können bekannte Umwelteinflüsse datensenderseitig kompensiert werden.

Bei Ausführungsbeispielen können [z.B. verbleibende] Umwelteinflüsse durch künstliche Abweichungen [z.B. der Signalparameter] verschleiert werden.

Bei Ausführungsbeispielen kann eine empfängerseitige Schätzgenauigkeit bestimmter Signalparameter durch eine Manipulation des Signals [z.B. der Signalparameter] reduziert werden.

Ausführungsbeispiele der vorliegenden Erfindung werden bezugnehmend auf die beiliegenden Figuren näher beschrieben. Es zeigen:
- Fig. 1: in einem Diagramm eine Abweichung eines hochfrequenten Taktgebers von der Referenzfrequenz in Abhängigkeit von der Temperatur;
- Fig. 2: in einem Diagramm eine Abweichung eines niederfrequenten Taktgebers von der Referenzfrequenz in Abhängigkeit von der Temperatur;
- Fig. 3a: zeigt eine schematische Ansicht eines Systems mit einem Datensender und einem Datenempfänger sowie eine Übertragung eines Signals zwischen dem Datensender und dem Datenempfänger, wobei der Datenempfänger durch Auswertung zumindest eines Signalparameters des Signals auf einen Umweltparameter in der Umgebung des Datensenders schließen kann, gemäß einem Ausführungsbeispiel der vorliegenden Erfindung;
- Fig. 3b: zeigt eine schematische Ansicht eines Systems eines Systems mit einem Datensender und einem Datenempfänger sowie eine Übertragung eines Signals zwischen dem Datensender und dem Datenempfänger mit einer Verschleierung zumindest eines Signalparameters des Signals, gemäß einem Ausführungsbeispiel der vorliegenden Erfindung;
- Fig. 4: ein schematisches Blockschaltbild eines Systems mit einem Datensender und einem Datenempfänger, gemäß einem Ausführungsbeispiel der vorliegenden Erfindung;
- Fig. 5: zeigt ein schematisches Blockschaltbild eines Systems mit einem Datensender und einem Datenempfänger, gemäß einem weiteren Ausführungsbeispiel der vorliegenden Erfindung;
- Fig. 6: zeigt ein schematisches Blockschaltbild eines Systems mit einem Datensender und einem Datenempfänger, gemäß einem weiteren Ausführungsbeispiel der vorliegenden Erfindung;
- Fig. 7: in einem Diagramm einen Temperaturverlauf des Senders des Datensenders beim Öffnen und Schließen eines Fensters mit und ohne Abschirmeinrichtung zur thermischen Abschirmung des Senders der Datensenders, aufgetragen über die Zeit;
- Fig. 8: ein schematisches Blockschaltbild eines Systems mit einem Datensender und einem Datenempfänger, gemäß einem Ausführungsbeispiel der vorliegenden Erfindung;
- Fig. 9: ein Flussdiagramm eines Verfahrens zum Betrieb eines Datensenders, gemäß einem Ausführungsbeispiel der vorliegenden Erfindung;
- Fig. 10: ein Flussdiagramm eines Verfahrens zum Senden eines Signals, gemäß einem Ausführungsbeispiel der vorliegenden Erfindung; und
- Fig. 11: ein Flussdiagramm eines Verfahrens zum Ermitteln eines Umweltparameters in der Umgebung eines Datensenders, gemäß einem Ausführungsbeispiel der vorliegenden Erfindung.

In der nachfolgenden Beschreibung der Ausführungsbeispiele der vorliegenden Erfindung werden in den Figuren gleiche oder gleichwirkende Elemente mit dem gleichen Bezugszeichen versehen, so dass deren Beschreibung untereinander austauschbar ist.

In typischen Funksystemen wird zur Erzeugung von Übertragungssignalen eine Referenzfrequenz benötigt, aus welcher der jeweilige Funkchip bzw. das jeweilige Frontend die notwendigen Takte ableitet. Diese Referenzfrequenz wird typischerweise durch einen Taktgeber, wie z.B. einen Schwingquarz (Quarz) [1], zur Verfügung gestellt. Datensender, wie z.B. Knoten bzw. Sensorknoten, umfassen in der Regel zwei unterschiedliche Taktgeber. Dies kann beispielsweise ein hochfrequenter (HF) Taktgeber, der mit einer Frequenz von mehrere MHz schwingt, und ein niederfrequenter Taktgeber (LF), der üblicherweise mit einer Frequenz von 32768 Hz schwingt, sein. Der hochfrequente Taktgeber ist in der Regel genauer (in Hinsicht auf die Abweichung von der Nominalfrequenz) und stromhungriger. Der niederfrequente ist ungenauer dafür aber sehr stromsparend.

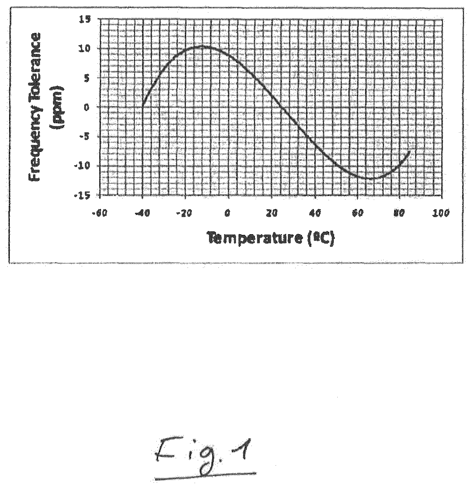

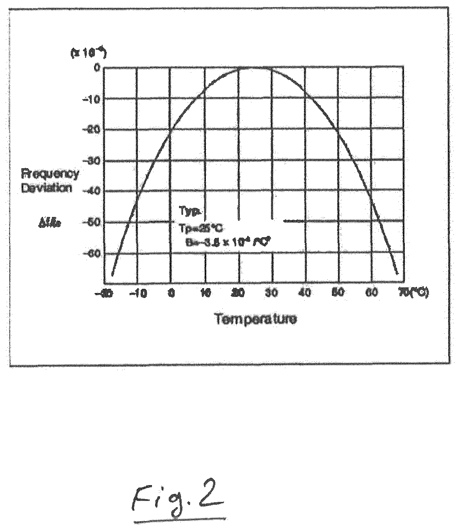

Die von den Taktgebern (Schwingquarzen) zur Verfügung gestellten Referenzfrequenzen sind jedoch typischerweise von Umweltparametern abhängig. In Fig. 1 ist beispielhaft die Abhängigkeit der Referenzfrequenz über der Temperatur für einen beliebigen hochfrequenten Taktgeber zu sehen (Frequenzstabilität eines hochfrequenten Schwingquarzes über der Umgebungstemperatur [2]), während in Fig. 2 beispielhaft die Abhängigkeit der Referenzfrequenz über der Temperatur für einen beliebigen niederfrequenten Taktgeber gezeigt ist (Frequenzstabilität eines niederfrequenten (LF) 32768 kHz Quarzes über der Temperatur [5]). Dabei beschreiben die Ordinaten jeweils die Frequenztoleranz in ppm und die Abszissen jeweils die Temperatur in °C.

Neben der Temperatur gibt es weitere Abhängigkeiten des Taktgebers (Quarzes) von zumindest folgenden Parametern:
- Luftfeuchtigkeit
- Druck
- EM-Strahlung
- Helligkeit
- Vibration/Bewegung

All diese Parameter haben einen Einfluss auf die vom Taktgeber (Schwingquarz) zur Verfügung gestellte Referenzfrequenz. Wird diese Referenzfrequenz für die Erzeugung der Übertragungssignale eingesetzt, wirken sich diese Abhängigkeiten direkt auf das Übertragungssignal und somit auf die Übertragungsparameter (Signaleigenschaften) aus. Folgende Übertragungsparameter sind dabei vor spezieller Bedeutung:
- Sendefrequenz
- Sendezeitpunkt
- Symbolrate
- Modulationsindex (bei Frequenzumtastungsverfahren, wie z.B. FSK oder GMSK)
- Doppler (nur bei Vibration/Bewegung)

Bei der Erzeugung und Abstrahlung eines Funksignals in einem Sender wirken sich somit Umgebungsbedingungen des Senders auf das abgestrahlte Funksignal aus. Insbesondere die Frequenz von Oszillatoren, die in dem Sender als Referenz für Träger- oder Modulationsfrequenzen dient, kann durch Umwelteinflüsse verändert werden. Beispielsweise korreliert bei nicht temperaturkorrigierten Oszillatoren (Quarzen) die Frequenz mit der Umgebungstemperatur. Analoge Effekte können auch für Luftfeuchtigkeit, Elektromagnetische Strahlung, Helligkeit oder Vibrationen auftreten. Darüber hinaus wirken sich Bewegungen oder Vibrationen des Senders und dessen Antenne durch Dopplerverschiebungen in dem abgestrahlten Signal aus.

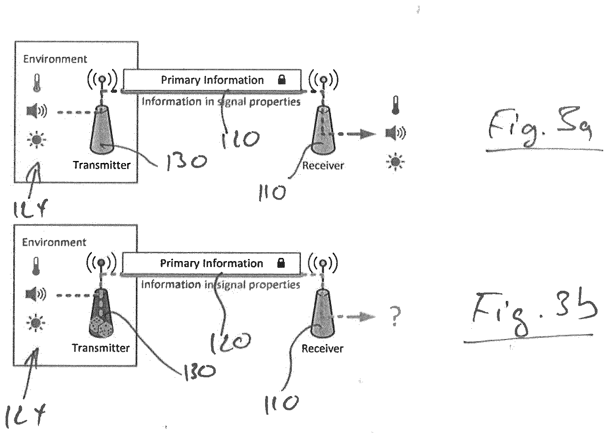

Durch diese Eigenschaften trägt das abgestrahlte Signal neben der Primärinformation weitere implizite Informationen über die Umgebungsbedingungen oder Eigenschaften des Senders. Zur Veranschaulichung ist dieses Phänomen grafisch in Fig. 3 gezeigt

Im Detail zeigt Fig. 3a eine schematische Ansicht eines Systems 100 mit einem Datensender 130 und einem Datenempfänger 110 sowie eine Übertragung eines Signals 120 zwischen dem Datensender 130 und dem Datenempfänger 110, wobei der Datenempfänger 110 durch Auswertung zumindest eines Signalparameters des Signals 120 auf einen Umweltparameter 124 in der Umgebung des Datensenders 130 schließen kann.

Wie in Fig. 3a zu erkennen ist, wirken sich die Umgebungsbedingungen auf Seiten des Datensenders 130 auf das von dem Datensender 130 gesendete Signal 120 aus, so dass das Signal 120 neben einer Primärinformation zusätzlich eine Information über die Umgebungsbedingungen in den Signaleigenschaften aufweist. Mit anderen Worten, Fig. 3a zeigt eine Funkkommunikation zwischen Sender 130 und Empfänger 110, wobei neben der gesendeten Primärinformation auch die Information über die Signaleigenschaften gezeigt ist.

Ist es nun möglich am Empfänger 110 die Signaleigenschaften zu bestimmen (z.B. zu schätzen), kann über den Zusammenhang der Signaleigenschaften mit den Umgebungsbedingungen direkt auf die Umgebungsbedingungen am Sender 130, am Empfänger 110 oder dazwischen geschlossen werden. Da die größten Toleranzen allerdings am Sender 130 entstehen werden meistens Umgebungsbedingungen am Sender bestimmt. Die Temperatur kann beispielsweise aus einem ermittelten Frequenzoffset (Abweichung zur erwarteten Nominalfrequenz) über die in Fig. 1 gezeigte Kurve am Sender bestimmt werden.

Moderne Software Defined Radio (SDR) Empfänger ermöglichen eine sehr genaue Bestimmung der Parameter eines empfangen Signals. So kann beispielsweise bereits eine Frequenzabweichung im Bereich weniger Hz erfasst werden. Dies erlaubt die vollständige oder teilweiße Rekonstruktion von Umgebungsbedingungen oder Eigenschaften des Senders aus den ermittelten Signalparametern im Empfänger.

Da diese Metainformationen durch physikalische Eigenschaften auf Signalebene transportiert werden, werden diese nicht durch übergeordnete Maßnahmen des Zugriffsschutzes wie Verschlüsslung erfasst. Die Rekonstruktion kann somit durch beliebige, nicht autorisierte, Empfänger erfolgen. Dies stellt eine erhebliche Problematik in Bezug auf Datenschutz und Sicherheit für alle Funksysteme mit Sendern in nicht-öffentlichen Bereichen dar.

Durch die hohe Dichte an Geräten mit Funkschnittstellen ergeben sich weitreichende Angriffsflächen. Potentielle Szenarien betreffen sowohl private Haushalte als auch industrielle oder staatliche Einrichtungen.

Hierbei ist die Bestimmung der Umgebungsbedingungen nicht von einem bestimmten Funksystem abhängig, es kann jedes beliebige Funksystem (z. B. WLAN, Bluetooth, Funkwetterstationen, ...) zur Bestimmung eigesetzt werden. Sind mehrere Systeme vorhanden, kann auch eine Kombination bei der Bestimmung angewendet werden.

Beispielsweise lässt sich an einem Temperaturverlauf über dem Tag feststellen, ob sich Personen ein einem Raum, einer Wohnung oder einem Haus aufhalten. Diese Information kann beispielsweise von Einbrechern genutzt oder zur Spionage benutzt werden.

Da häufig neben der Bestimmung der Umgebungsbedingungen auch eine Lokalisierung der Sender erfolgen kann, handelt es sich um personenbezogene Daten, welche nach dem neuen Datenschutzgesetz pseudonymisiert sein müssen [4].

Ausführungsbeispiele der vorliegenden Erfindung befassen sich mit Techniken, mit denen die Signaleigenschaften und somit die Umgebungsbedingungen verschleiert werden können, wie dies in Fig. 3b angedeutet ist.

Im Detail zeigt Fig. 3b eine schematische Ansicht eines Systems mit einem Datensender 130 und einem Datenempfänger 110 sowie eine Übertragung eines Signals 120 zwischen dem Datensender und dem Datenempfänger mit einer Verschleierung zumindest eines Signalparameters des Signals 120, gemäß einem Ausführungsbeispiel der vorliegenden Erfindung. Bedingt durch eine Verschleierung zumindest eines Signalparameters des Signals 120 ist es dem Datenempfänger 110 nicht mehr möglich durch Auswertung des zumindest einen Signalparameters auf einen Umweltparameter 124 in der Umgebung des Datensenders 130 zu schließen.

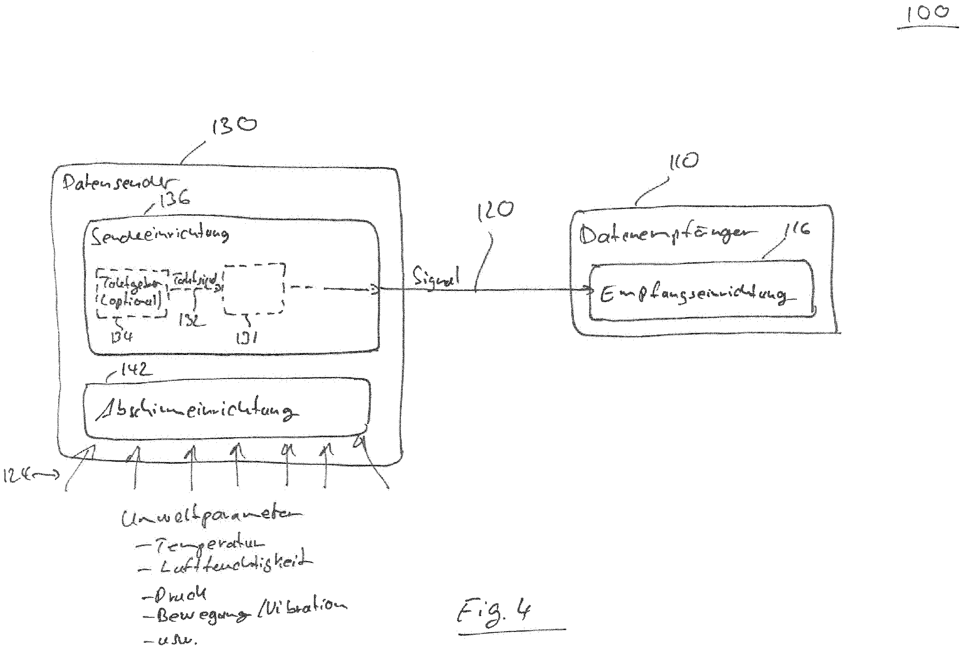

Fig. 4 zeigt ein schematisches Blockschaltbild eines Systems 100 mit einem Datensender 130 und einem Datenempfänger 110, gemäß einem Ausführungsbeispiel der vorliegenden Erfindung.

Der Datensender 130 umfasst eine Sendeeinrichtung 136 (z.B. Sender, Funkchip / Frontend), die ausgebildet ist, um ein Signal 120 zu senden.

Der Datenempfänger 110 umfasst eine Empfangseinrichtung 116 (z.B. Empfänger), die ausgebildet ist, um das Signal 120 zu empfangen.

Ein Umweltparameter 124, der auf den Datensender 130 einwirkt, kann die Sendeeinrichtung 136 oder eine Einrichtung der Sendeeinrichtung 136, wie z.B. einen Taktgeber 134 der Sendeeinrichtung 136, beeinflussen, so dass zumindest ein Signalparameter des von der Sendeinrichtung 136 erzeugten Signals 120 von dem Umweltparameter 124 in der Umgebung des Datensenders 130 abhängig ist.

Beispielsweise kann ein Umweltparameter 124 (z.B. eine Temperatur oder Temperaturänderung), der auf den Taktgeber 134 der Sendeeinrichtung 136 einwirkt, den Taktgeber 134 und damit zumindest einen Taktsignalparameter (z.B. Taktfrequenz) des von dem Taktgeber 134 bereitgestellten Taktsignals 132 beeinflussen. Da eine Erzeugung des von dem Datensender 130 gesendeten Signals 120 auf dem Taktsignal 132 des Taktgebers 134 basiert, z.B. über eine Signalverarbeitungskette 131, die basierend auf dem Taktsignal 132 das Signal 120 erzeugt, beeinflusst der Umweltparameter 124 nicht nur einen Taktsignalparameter (z.B. Taktfrequenz) des Taktsignals 132, sondern auch einen Signalparameter (z.B. eine Signaleigenschaft, wie z.B. eine Trägerfrequenz) des von der Sendeeinrichtung 136 erzeugten Signals (Sendesignal) 120.

Der Datenempfänger 110 kann somit durch Auswerten des Signalparameters 112 des empfangenen Signals 120 auf den Umweltparameter (z.B. Temperatur) in der Umgebung des Datensenders 130 schließen bzw. diesen schätzen.

Bei Ausführungsbeispielen umfasst der Datensender 130 daher eine Abschirmeinrichtung 142, die ausgebildet ist, um die Sendeeinrichtung 136 oder einen Teil der Sendeeinrichtung 136 (z.B. den Taktgeber 134 der Sendeeinrichtung) von dem Umweltparameter 124 abzuschirmen, um eine empfängerseitige, rekonstruierbare Auswirkung des Umweltparameters 124 auf den zumindest einen Signalparameter zu reduzieren (z.B. um eine empfängerseitige Schätzung des Umweltparameters basierend auf dem zumindest einen Signalparameter zu erschweren).

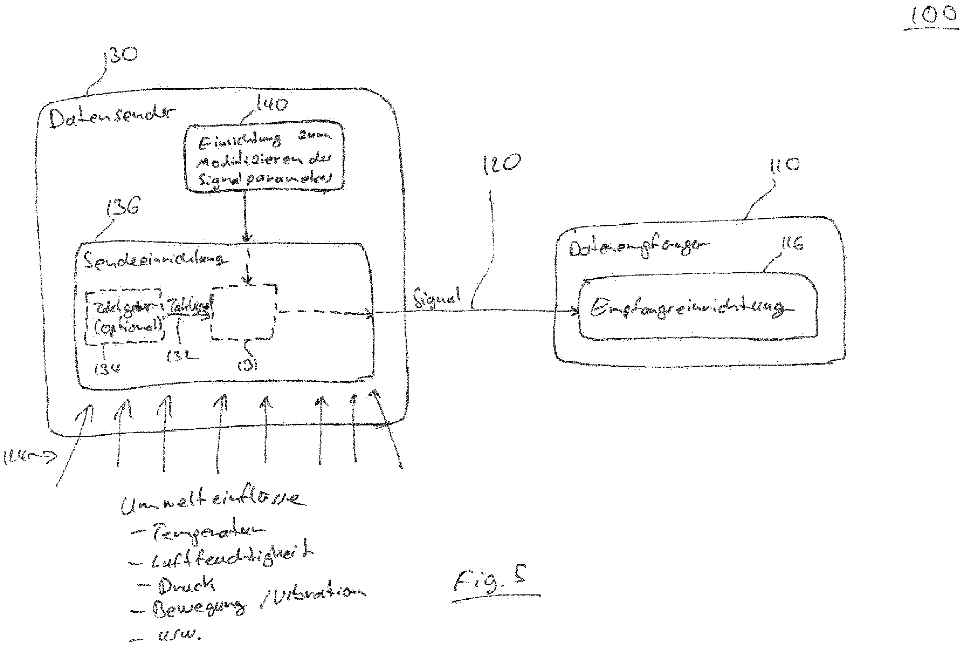

Fig. 5 zeigt ein schematisches Blockschaltbild eines Systems 100 mit einem Datensender 130 und einem Datenempfänger 110, gemäß einem Ausführungsbeispiel der vorliegenden Erfindung.

Im Vergleich zu dem in Fig. 4 gezeigtem Ausführungsbeispiel umfasst der Datensender 130 statt der Abschirmeinrichtung 142 eine Einrichtung 140 zum Modifizieren (z.B. Verändern) eines Signalparameters, die ausgebildet ist, um zumindest einen Signalparameter des Signals zu modifizieren, um eine empfängerseitige, rekonstruierbare Auswirkung des Umweltparameters auf den zumindest einen Signalparameter zu reduzieren [z.B. um eine empfängerseitige Schätzung des Umweltparameters basierend auf dem zumindest einen Signalparameter zu erschweren].

Die Einrichtung 140 zum Modifizieren des Signalparameters kann dabei ausgebildet sein, um den zumindest einen Signalparameter direkt zu modifizieren (z.B. und nicht das von dem Taktgeber 134 bereitgestellte Taktsignal 132). Beispielsweise kann die Einrichtung 140 zum Modifizieren des Signalparameters ausgebildet sein, um den Signalparameter (z.B. direkt) mit einem Offset zu beaufschlagen, um den Signalparameter zu modifizieren. Zum Beispiel kann die Einrichtung 140 zum Modifizieren des Signalparameters ausgebildet sein, um eine Trägerfrequenz (=Signalparameter) mit einem Trägerfrequenzoffset, eine Signalphase (=Signalparameter) mit einem Signalphasenoffset, einen Modulationsindex (=Signalparameter) mit einem Modulationsindexoffset, eine Symbolrate (=Signalparameter) mit einem Symbolratenoffset, und/oder eine Signalleistung (=Signalparameter) mit einem Signalleistungsoffset zu beaufschlagen.

Alternativ (oder zusätzlich) kann die Einrichtung zum Modifizieren des Signalparameters ausgebildet sein, um ein von dem Taktsignal 132 des Taktgebers 134 abgeleitetes Signal, von dem das Signal 120 oder eine Erzeugung des Signals 120 abhängig ist, zu modifizieren, um den zumindest einen Signalparameter zu modifizieren (z.B. und nicht das von dem Taktgeber 134 bereitgestellte Taktsignal 132). Beispielsweise kann die Einrichtung 140 zum Modifizieren des Signalparameters ausgebildet sein, um ein Signal einer Signalverarbeitungskette 131 der Sendeeinrichtung 136, die basierend auf dem Taktsignal 132 das Signal 120 erzeugt, zu modifizieren, um den zumindest einen Signalparameter zu modifizieren. Beispielsweise kann die Signalverarbeitungskette 131, die dem Taktgeber 134 nachgeschaltet ist, einen Taktteiler/Taktvervielfacher aufweisen, der ausgebildet ist, um eine Taktfrequenz des Taktsignals 132 zu teilen/vervielfachen, oder einen einstellbaren Kondensator, der ausgebildet ist, um das Taktsignal 132 oder ein davon abgeleitetes Signal zu modifizieren, um den zumindest einen Signalparameter des Signals 120 zu modifizieren.

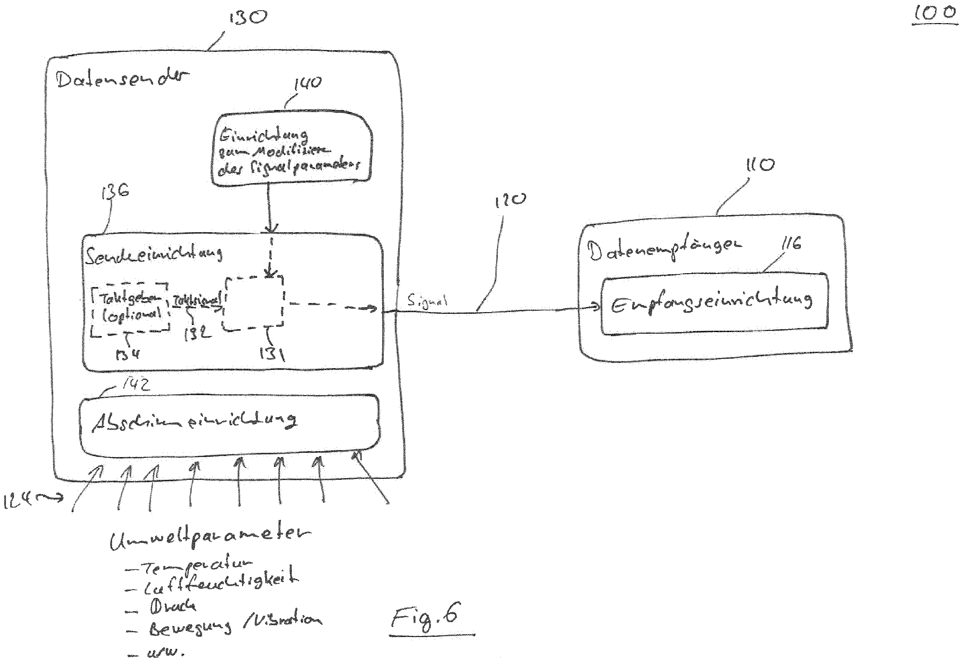

Fig. 6 zeigt ein schematisches Blockschaltbild eines Systems 100 mit einem Datensender 130 und einem Datenempfänger 110, gemäß einem Ausführungsbeispiel der vorliegenden Erfindung.

Im Vergleich zu den in den Fig. 4 und 5 gezeigten Datensendern 130, umfasst der in Fig. 6 gezeigte Datensender 130 sowohl die Abschirmeinrichtung 142 als auch die Einrichtung 140 zum Modifizieren des Signalparameters.

Die Abschirmeinrichtung 142 und die Einrichtung 140 zum Modifizieren des Signalparameters können sich dabei ergänzen. Beispielsweise können durch die Einrichtung 140 zum Modifizieren des Signalparameters verbleibende Auswirkungen der Umweltparameter auf einen oder mehrere Signalparameter, die durch die Abschirmeinrichtung 142 nicht oder nur teilweise kompensiert bzw. neutralisiert werden, reduziert werden. Kompensiert bzw. neutralisiert bezieht sich hierin dabei darauf, dass die Auswirkungen des Umweltparameters auf den Signalparameter soweit reduziert werden, dass eine empfängerseitige Schätzung des Umweltparameters basierend auf dem Signalparameter nicht möglich oder zu ungenau ist.

Im Folgenden werden weitere Ausführungsbeispiele des Datensenders 130 und/oder Datenempfängers beschrieben. Die folgenden Ausführungsbeispiele sind dabei auf jeden der in den Fig. 4 bis 6 gezeigten Datensender 130 anwendbar.

### 1. Abschirmung gegen Umwelteinflüsse

Durch Abschirmung des Senders 136 (oder des Datensenders 130) gegen Umwelteinflüsse können die Auswirkungen auf die Signaleigenschaften reduziert oder vermieden werden. Im Falle der Umgebungstemperatur kann beispielsweise durch thermische Isolation des Senders 136 (oder des Datensenders 130) die Trägheit gegenüber Temperatureinflüssen erhöht werden.

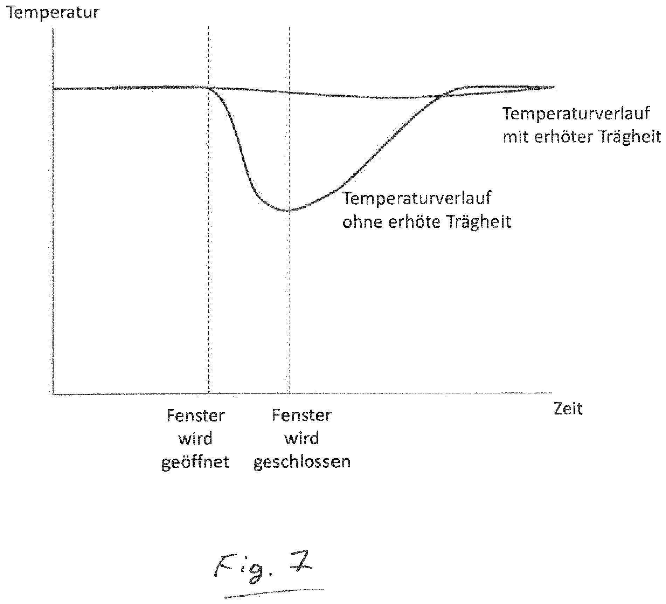

Wird die zeitliche Auflösung hierdurch ausreichend reduziert, kann eine Rekonstruktion von Temperaturereignissen, wie das Öffnen von Fenstern und Türen oder die Anwesenheit von Personen, vermieden oder zumindest deutlich erschwert werden, wie dies in Fig. 7 angedeutet ist. Analog gilt dies für Luftfeuchtigkeit, Luftdruck, EM-Strahlung und Helligkeit.

Im Detail zeigt Fig. 7 in einem Diagramm einen Temperaturverlauf des Senders 136 des Datensenders 130 beim Öffnen und Schließen eines Fensters mit und ohne Abschirmeinrichtung 142 zur thermischen Abschirmung des Senders 136 der Datensenders, aufgetragen über die Zeit. Dabei beschreibt die Ordinate die Temperatur und die Abszisse die Zeit.

Vibrationen können durch Dämpfung oder Entkopplung von der Vibrationsquelle ebenfalls reduziert oder in Frequenzbereiche verschoben werden, die eine Rekonstruktion im Empfänger vermeiden oder erschweren.

Hierbei kann die Abschirmung gezielt gegen Einflüsse erfolgen, welche Rückschlüsse auf Ereignisse oder Zustände zulassen, welche nach außen nicht sichtbar sein sollen. Andere Einflüsse, ohne Nutzen für eine Rekonstruktion, können dagegen als erwünschte Verschleierung erhalten bleiben.

Bei Ausführungsbeispielen kann auf Datensenderseite eine gezielte Abschirmung gegen Umwelteinflüsse erfolgen, um die rekonstruierbaren Auswirkungen auf Signaleigenschaften zu reduzieren oder zu vermeiden.

Bei Ausführungsbeispielen kann auf Datensenderseite ein Kühlkörper (zur Kühlung des Senders 136 oder zumindest eines Teils des Senders 136) angebracht werden, um die thermische Stabilität und/oder Trägheit zu erhöhen.

Bei Ausführungsbeispielen kann auf Datensenderseite eine Heizung angebracht werden und vor dem Senden (der Sender 136 oder zumindest ein Teil des Senders 136) definiert (auf)geheizt werden.

Bei Ausführungsbeispielen kann auf Datensenderseite der Mikrokontroller (des Datensenders 130) als Heizung genutzt werden. Beispielsweise kann eine thermische Kopplung (des Senders 136 oder zumindest eines Teils des Senders 136) an den Mikrokontroller hergestellt und z.B. rechenintensive Programme ausgeführt werden.

Bei Ausführungsbeispielen können auf Datensenderseite Programme (die auf dem Mikrocontroller ausgeführt werden) so getimed werden, dass vor dem Senden (z.B. immer) definierte Zeiten zum Heizen vorhanden sind. Falls keine notwendigen/sinnvollen Berechnungen anstehen können Dummy Berechnungen durchgeführt werden.

Bei Ausführungsbeispielen kann auf Datensenderseite, abhängig von der Tageszeit (z.B. Tag/Nacht) und/oder der Jahreszeit (z.B. Sommer/Winter), usw., (z.B. mit dem Mikrocontroller oder einem anderen Heizelement) unterschiedlich lange geheizt werden.

### 2. Anpassung der Signaleigenschaften

Sind die Umwelteinflüsse zumindest teilweiße im Datensender 130 bekannt, können diese gezielt kompensiert werden. Insbesondere die aktuelle Abweichung eines Oszillators (Quarzes) 134 vom Sollwert kann über die Kennlinie des Oszillators 134 bestimmt werden.

Zur Bestimmung der Abweichung vom Sollwert kann beispielsweise eine (oder mehrere) der folgenden Methoden eingesetzt werden:
- Sensor auf dem Sender (der Sensor kann die Umgebungsbedingungen direkt bestimmen),
- Signalisierung durch vorherige Übertragung vom Empfänger (Empfänger ermittelt die Abweichung aus Übertragungen des Senders und/oder anderen Sendern mit korrelierten Umwelteinflüssen oder Empfänger besitzt Seitenkanalinformationen),
- Bestimmung der Abweichung vom Sollwert aus den Signaleigenschaften einer vorherigen Übertragung des Empfängers,
- Bestimmung der Abweichung vom Sollwert über eine genaue Referenz (z. B. GPS-Modul),
- Bestimmung der Abweichung aus anderen Funksignalen mit bekannter, temperaturstabilisierter, (Träger-)Frequenz (z.B. Mobilfunkbasisstationen, DCF Zeitsignal, etc.), und
- Bestimmung durch Differenzielle Betrachtung von zwei oder mehr vorhandenen Quarzen mit bekannten Kennlinien.

Mit Hilfe der bekannten Abweichung des Oszillators 134 vom Sollwert lassen sich die Signaleigenschaften entsprechend anpassen, so dass die zuvor berechneten Abweichungen kompensiert werden. Beispielsweise kann die Trägerfrequenz des Übertragungssignals modifiziert werden und/oder der Zeitpunkt der Aussendung entsprechend verschoben werden. In ähnlicher Weise kann das für die die anderen genannten Signaleigenschaften erfolgen.

Bei Ausführungsbeispielen kann auf Datensenderseite eine Bestimmung der Abweichung vom Sollwert durchgeführt werden und auf Basis dieser Parameter die Umweltwelteinflüsse in den Signaleigenschaften gezielt korrigiert werden.

Bei Ausführungsbeispielen kann auf Datenempfängerseite eine Rückmeldung von ermittelten, geschätzten Umwelteinflüssen auf Senderseite an den Sender erfolgen.

Bei Ausführungsbeispielen kann auf Datensenderseite aufgrund einer gemessenen Empfangs-RSSI die Sendeleistung eingestellt werden.

### 3. Nachregelung der Referenzfrequenz

Falls die Referenzfrequenz im Sender 136 angepasst werden kann, z.B. durch eine konfigurierbare Phasenregelschleife oder durch Beeinflussung des Quarzes 134 über einen Kondensator oder die Eingangsspannung, wie z.B. bei einem spannungsgesteuerten Oszillator (engl. voltage controlled oscillator), können die ermittelten Umwelteinflüsse auch direkt in der Referenzfrequenz kompensiert werden. Die Referenzfrequenz wird also so verschoben, dass diese unter Berücksichtigung der ermittelten Umwelteinflüsse wieder dem Sollwert entspricht.

Die Bestimmung der Umwelteinflüsse kann hierbei analog zu Abschnitt 2 erfolgen.

Bei Ausführungsbeispielen kann auf Datensenderseite auf Basis der ermittelten Umwelteinflüsse die angeforderte Referenzfrequenz so abgeändert werden, dass diese wieder dem Sollwert entspricht.

### 4. Korrektur der abgeleiteten Frequenzen

Für die Signalerzeugung werden häufig von der Referenzfrequenz abgeleitete Frequenzen verwendet. Werden diese durch variable Teiler erzeugt, kann ein bekannter Referenzfrequenzfehler durch Anpassung der Teiler in den abgeleiteten Frequenzen korrigiert werden. Dies kann auch mit einer Nachregelung der Referenzfrequenz kombiniert werden um z.B. eine Feinkorrektur zwischen diskreten Frequenzstufen einer Referenzfrequenz durchzuführen.

Die Bestimmung der Umwelteinflüsse kann hierbei analog zu Abschnitt 2 erfolgen.

Bei Ausführungsbeispielen können auf Datensenderseite bei der Erzeugung von abgeleiteten Frequenzen zur Signalerzeugung ermittelte Umwelteinflüsse durch Anpassung der Teiler kompensiert werden.

In der Regel wird ein Pierce Oszillator um den Quarz aufgebaut um die Frequenz zu generieren. In dem Pierce Oszillator wird parallel zu dem Quarz ein/zwei Kondensator/en eingeschaltet die zusammen mit dem Quarz den Schwingkreis bilden und damit die Resonanzfrequenz bestimmen, siehe [5], C1 und C2. Die genannten Kondensatoren sind meistens auf einem IC (=integrated circuit, dt. integrierter Schaltkreis) mit dem Mikrokontroller/Funk IC integriert. Die Kondensatoren sind auch einstellbar. Damit kann die gewünschte Frequenz geändert werden. Damit ändert sich die Referenzfrequenz die für die Bildung von Trägerfrequenz/Symbolrate/Frequenzhub zuständig ist.

Alternativ können einstellbare Kapazitäten auf der Leiterplatte vorgesehen werden (z.B. Kapazitätsdiode), die gesteuert werden können.

Bei Ausführungsbeispielen können bei der Erzeugung von abgeleiteten Frequenzen ermittelte Umwelteinflüsse durch Anpassung von einstellbaren Kondensatoren kompensiert werden.

Bei Ausführungsbeispielen können die Offsets direkt eingestellt werden, indem der Mikrokontroller Korrekturwerte für die Trägerfrequenz und Symbolrate angibt.

### 5. Empfangsseitige Bestimmung von Umweltparametern eines Datensenders

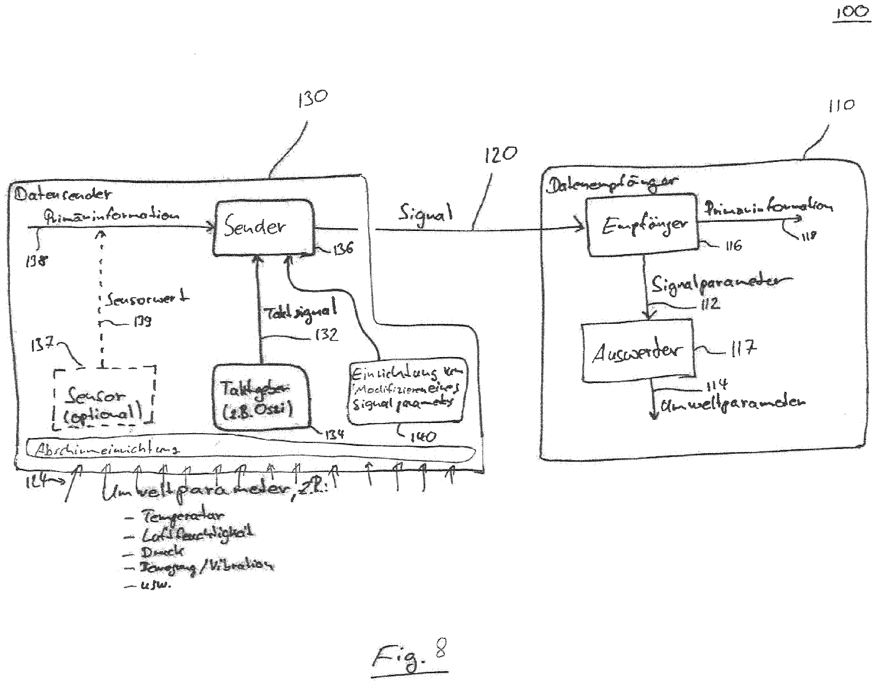

Fig. 8 zeigt ein schematisches Blockschaltbild eines Systems 100 mit einem Datensender 130 und einem Datenempfänger 110, gemäß einem Ausführungsbeispiel der vorliegenden Erfindung.

Der Datenempfänger 110 ist ausgebildet, um ein Signal 120 des Datensenders 130 zu empfangen, wobei das Signal 120 von einem Taktsignal 132 eines Taktgebers 134 (z.B. eines Frequenzgebers, wie z.B. eines Oszillators bzw. Quarzes) des Datensenders 130 abhängig ist. Der Datenempfänger 110 ist ferner ausgebildet, um einen Signalparameter 112 (z.B. eine Signaleigenschaft, wie z.B. eine Trägerfrequenz oder Trägerfrequenzabweichung) des Signals 120 zu ermitteln (z.B. auszuwerten), und um basierend auf dem Signalparameter 112 einen Umweltparameter 114 (z.B. eine Temperatur oder Temperaturänderung) zu ermitteln (z.B. zu schätzen), dem der Taktgeber 134 des Datensenders 110 und/oder dem das Signal 120 ausgesetzt ist.

Wie in Fig. 8 beispielhaft gezeigt ist, kann der Datensender 130 einen Sender 136 (Funkchip / Frontend) aufweisen, der ausgebildet ist, um das Signal 120 (Sendesignal) zu erzeugen, wobei das Signal 120 vom dem Taktsignal 132 des Taktgebers 134 abhängig ist. Beispielsweise kann der Sender 136 mit dem Taktsignal 132 des Taktgebers 134 getaktet sein, so dass das Signal 120 von dem Taktsignal 132 des Taktgebers 134 abhängig ist.

Ein Umweltparameter 124 (z.B. eine Temperatur oder Temperaturänderung), der auf den Taktgeber 134 des Datensenders 130 einwirkt, beeinflusst den Taktgeber 134 und damit zumindest einen Signalparameter (z.B. Frequenz) des von dem Taktgeber 134 bereitgestellten Taktsignals 132. Da das von dem Datensender 130 gesendete Signal 120 von dem Taktsignal 132 abhängig ist, beeinflusst der Umweltparameter 124 nicht nur einen Signalparameter (z.B. Frequenz) des Taktsignals 132, sondern auch einen Signalparameter (z.B. eine Signaleigenschaft, wie z.B. Trägerfrequenz) des von dem Datensender 130 gesendeten Signals 120.

Der Datenempfänger 110 kann somit durch Auswerten des Signalparameters 112 des empfangenen Signals 120 auf den Umweltparameter (z.B. Temperatur) in der Umgebung des Datensenders 130 schließen bzw. diesen schätzen.

Der Signalparameter 112 ist dabei unabhängig von einem Modulationsinhalt des Signals 120, wie z.B. von einer modulierten Primärinformation, die das Signal 120 aufweist.

Beispielweise kann der Datensender 130 (bzw. der Sender 136 des Datensenders 130) ausgebildet sein, um eine Primärinformation 138 (z.B. eine ID (=Identifikator) des Datensenders 130, eine Synchronisationssequenz/Pilotsequenz, Nutzdaten und/oder Dummy-Daten) zu modulieren, so dass das Signal 120 eine modulierte Primärinformation aufweist. Neben der modulierten Primärinformation enthält das Signal 120 jedoch zusätzlich eine Information über den Umweltparameter 124 (in der Umgebung des Datensenders 130) in dem Signalparameter 112, den der Datenempfänger 130 auswerten kann, um auf den Umweltparameter 114 zu schließen.

Wie in Fig. 8 beispielhaft gezeigt ist, kann der Datenempfänger 110 einen Empfänger 116 aufweisen, der ausgebildet ist, um das empfangenen Signal 120 zu demodulieren, um die in dem Signal 120 enthaltene Primärinformation 118 zu erhalten. Ferner kann der Datenempfänger 110 (z.B. der Empfänger 116 des Datenempfängers 110) ausgebildet sein, um den Signalparameter 112 des empfangenen Signals 120 zu ermitteln bzw. auszuwerten, um die in dem Signal 120 zusätzlich enthaltene Information über den Umweltparameter 124 zu erhalten. Beispielsweise kann der Datenempfänger 110 hierzu einen Auswerter 117 (z.B. einen Prozessor) aufweisen, der ausgebildet ist, um basierend auf dem Signalparameter 112 den Umweltparameter 114 zu ermitteln (z.B. zu schätzen), zum Beispiel basierend auf einer Abbildungsfunktion, die den Signalparameter 112 auf den Umweltparameter 114 abbildet.

Bei Ausführungsbeispielen kann der Datensender 130 (bzw. der Sender 136 des Datensenders 130) ausgebildet sein, um als Signal 120 ein digital moduliertes Signal 120 bereitzustellen. Der Datenempfänger 110 kann dabei ausgebildet sein, um einen analogen Signalparameter 112 (z.B. eine analoge Signaleigenschaft, wie z.B. eine Trägerfrequenz) des digital modulierten Signals 120 zu ermitteln, und basierend auf dem analogen Signalparameter 112 den Umweltparameter 114 zu ermitteln. Der analoge Signalparameter 112 ist dabei unabhängig von einem Modulationsinhalt des digital modulierten Signals 120, wie z.B. von einer digital modulierten Primärinformation, die das Signal 120 aufweist.

Bei Ausführungsbeispielen ist es somit möglich, basierend auf dem (analogen) Signalparameter 112 den Umweltparameter in der Umgebung des Datensenders 130 zu schätzen, ohne dass der Umweltparameter hierfür explizit in dem Modulationsinhalt des Signals 120, d.h. in der modulierten Primärinformation des Signals 120, übertragen werden muss.

Obwohl mit dem Signal 120 also primär ganz andere Nutzdaten oder auch nur eine ID des Datensenders und/oder eine Synchronisationssequenz/Pilotsequenz übertragen werden, ist es trotzdem möglich, basierend auf dem (analogen) Signalparameter 112 den Umweltparameter in der Umgebung des Datensenders 130 zu ermitteln.

Die Ermittlung des Umweltparameters in der Umgebung des Datensenders 130 basierend auf dem (analogen) Signalparameter des empfangen Signals 120 schafft ein breites Spektrum von Anwendungsmöglichkeiten.

So kann gem. Ausführungsbeispielen der Datensender 130, wie dies in Fig. 8 beispielhaft angedeutet ist, einen Sensor 137 für einen Umweltparameter 124 aufweisen. Da der Umweltparameter auf Seiten des Datenempfängers 110 auch basierend auf dem (analogen) Signalparameter 112 des Signals 120 ermittelt werden kann, ist es nicht mehr erforderlich den Sensorwert 139 regelmäßig bzw. mit jeder Aussendung des Signals 120 in der modulierten Primärinformation des Signals 120 zu übertragen. Vielmehr genügt es mit dem Signal 120 als modulierte Primärinformation eine Synchronisationssequenz/Pilotsequenz und/oder eine ID des Datensenders 130 oder aber auch nur Dummy-Daten zu übertragen. Hierdurch kann die mit dem Signal 120 übertragene Datenmenge reduziert werden, wodurch auch die zur Übertragung des Signals 120 erforderliche Energie reduziert werden kann, was insbesondere für batteriebetriebenen Datensender 130 von Vorteil ist. Auch muss der Sensor 137 nicht mehr für jede Aussendung des Signals 120 aktiviert werden, wodurch der Energieverbrauch weiter reduziert werden kann. Natürlich kann der von dem Sensor 137 bereitgestellte Sensorwert 139 zusätzlich in einer Aussendung oder einer geringen Anzahl (Teilmenge) von Aussendungen des Signals 120 in der modulierten Primärinformation mit übertragen werden und auf Seiten des Datenempfängers 110 beispielsweise zur Kalibrierung oder Initialisierung genutzt werden. Genauso ist es möglich auf Seiten des Datensenders 130 vollständig auf den Sensor 137 für den Umweltparameter zu verzichten und/oder den Umweltparameter auf Seiten des Datenempfängers 110 ausschließlich basierend auf dem ermittelten Signalparameter 112 des empfangen Signals 120 zu ermitteln.

Ferner ist es durch die Ermittlung des Umweltparameters auf Seiten des Datenempfängers 110 basierend auf dem (analogen) Signalparameter 112 des Signals 120 möglich, einen Datensender 130, der einen Sensor 137 für einen ersten Umweltparameter aufweist, ebenfalls als Sensor für einen zweiten Umweltparameter zu verwenden. Beispielsweise kann gem. Ausführungsbeispielen der Datensender 130 einen Sensor 137 für einen ersten Umweltparameter 124 (z.B. Luftfeuchtigkeit oder Druck) aufweisen, wobei der Datenempfänger 110 ausgebildet ist, um basierend auf dem ermittelten Signalparameter 112 des Signals 120 einen zweiten Umweltparameter (z.B. Temperatur) zu ermitteln, wobei der erste Umweltparameter und der zweite Umweltparameter unterschiedlich sind.

Des Weiteren ist es durch die Ermittlung des Umweltparameters auf Seiten des Datenempfängers 110 basierend auf dem (analogen) Signalparameter 112 des empfangenen Signals 120 möglich, einen Datensender 130 als Sensor für einen Umweltparameter zu verwenden, der keinen Sensor für den Umweltparameter aufweist.

Darüber hinaus ist es möglich einen vorhandenen Datensender 130 als Sensor für einen Umweltparameter (z.B. als Temperatursensor) zu verwenden, obwohl der Datensender 130 an sich nicht als Sensor für den Umweltparameter vorgehsehen ist, beispielsweise da der Datensender 130 über keinen Sensor für den Umweltparameter verfügt oder aber auch weil der Datensender 130 den Sensorwert nicht übertragen kann.

Der Datensender 130 und der Datenempfänger 110 können optional ausgebildet sein, um Daten 120 unter Verwendung des Telegram-Splitting-Verfahrens (dt. Telegrammaufteilungsverfahrens) zu senden bzw. zu empfangen. Hierbei wird ein Telegramm bzw. Datenpaket in eine Mehrzahl von Sub-Datenpakete (oder Teildatenpakete, oder Teilpakete) aufgeteilt und die Sub-Datenpakete entsprechend eines Sprungmusters in der Zeit verteilt und/oder in der Frequenz verteilt von dem Datensender 130 zu dem Datenempfänger 110 übertragen, wobei der Datenempfänger 110 die Sub-Datenpakete wieder zusammenfügt (oder kombiniert), um das Datenpaket zu erhalten. Jedes der Sub-Datenpakete enthält dabei nur einen Teil des Datenpakets. Das Datenpaket kann ferner kanalcodiert sein, so dass zum fehlerfreien Decodieren des Datenpakets nicht alle Sub-Datenpakete sondern nur ein Teil der Sub-Datenpakete erforderlich ist. Die zeitliche Verteilung der Mehrzahl von Sub-Datenpaketen kann entsprechend eines Zeit- und/oder Frequenzsprungmusters erfolgen.

Da der Umweltparameter 124 in der Umgebung des Datensenders 130 jedoch nicht nur von dem Datenempfänger 110 basierend auf dem Signalparameter ermittelt (z.B. geschätzt) werden kann, sondern theoretisch auch von einem anderen Datenempfänger, bei dem es sich potentiell um einen Angreifer handeln kann, umfasst der Datensender 130, wie dies hierin bereits ausführlich beschrieben wurde, die Einrichtung 140 zum Modifizieren (z.B. Verändern oder Verschleiern) eines Signalparameters (siehe auch Fig. 5 und 6), die ausgebildet ist, um zumindest einen Signalparameter (z.B. Modulationsindex, Symbolrate, Sendezeitpunkt, Trägerfrequenz, Phase) des Signals 120 oder einen Parameter (z.B. Taktsignal 132), von dem der Signalparameter des Signals 120 abhängig ist, zu verändern (z.B. modifizieren, verschleiern, verfälschen oder verschlechtern), und/oder die Abschirmeinrichtung 142 (siehe auch Fig. 4 und 6), die ausgebildet ist, um die Sendeeinrichtung 136 oder einen Teil der Sendeeinrichtung 136 (z.B. den Taktgeber 134 der Sendeeinrichtung) von dem Umweltparameter 124 abzuschirmen, um eine empfängerseitige, rekonstruierbare Auswirkung des Umweltparameters 124 auf den zumindest einen Signalparameter zu reduzieren (z.B. um eine empfängerseitige Schätzung des Umweltparameters basierend auf dem zumindest einen Signalparameter zu erschweren).

Damit der Datenempfänger 110 den Umweltparameter 124 in der Umgebung des Datensenders 130 trotzdem basierend auf dem zumindest einen Signalparameter ermitteln kann, kann der Datenempfänger 110 bei Ausführungsbeispielen ausgebildet sein, um die datensenderseitige Modifizierung (z.B. Veränderung) des Signalparameters vor der Schätzung des Signalparameters oder des Umweltparameters zu kompensieren.

Bei Ausführungsbeispielen kann dem Datenempfänger 110 die datensenderseitige Modifizierung (z.B. Veränderung) des Signalparameters (z.B. der Offset, mit dem der Signalparameter datensenderseitig beaufschlagt ist) bekannt sein.

Bei Ausführungsbeispielen kann der Datenempfänger ausgebildet sein, um die datensenderseitige Modifizierung (z.B. Veränderung) des Signalparameters (z.B. den Offset, mit dem der Signalparameter datensenderseitig beaufschlagt ist) von einem immanenten Parameter des Kommunikationssystems des Datenempfängers oder einer mit dem Signal übertragenen Nachricht abzuleiten.

Bei Ausführungsbeispielen kann der Datenempfänger ausgebildet sein, um die datensenderseitige Modifizierung (z.B. Veränderung) des Signalparameters (z.B. den Offset, mit dem der Signalparameter datensenderseitig beaufschlagt ist) von einem dem Datensender und dem Datenempfänger bekannten kryptografischen Schlüssel abzuleiten.

Im Folgenden werden weitere Ausführungsbeispiele des Datenempfängers 110 und/oder Datensenders 130 näher beschrieben.

### 5.1 Bekannte Einflüsse Abziehen

Manche Systeme verwenden pseudozufällige Abweichungen z.B. im Frequenz- und/oder Zeitbereich. Das würde bei der Schätzung der Umweltparameter (z.B. Temperaturschätzung) zu falschen Ergebnissen führen. Die pseudozufälligen Abweichungen folgen in der Regel allerdings nach einem bekannten Muster. Ist dieser pseudozufällige Offset, welcher durch Würfeln ermittelt wurde (oder die Vorschrift wie er bestimmt wird), dem Datenempfänger 130 (z.B. Basisstation) bekannt, dann kann dieser Wert vom Empfangsparameter abgezogen werden, bevor die Umrechnung in den Umweltparameter erfolgt.

Bei Ausführungsbeispielen können bekannte, künstlich hinzugefügte Änderungen der Signalparameter (Empfangsparameter) rausgerechnet werden, wie z.B. eine pseudozufällige Abweichung der Sendezeiten oder der Frequenzoffsets.

Ferner können absichtliche Verschleierungen, wie oben beschrieben, abgezogen werden. Damit funktioniert die Schätzung der Empfangsparameter genauso, wie wenn die Verschleierungen nicht aufgebracht wären. Voraussetzung hierfür ist jedoch, dass dem Empfänger die Werte der Verschleierung vorliegen.

Bei Ausführungsbeispielen können hardwarespezifische Fehler rausgerechnet (z.B. abgezogen) werden, die z.B. durch die Sendehardware des Knotens hinzugefügt werden.

Bei Ausführungsbeispielen können datensenderspezifische (z.B. knotenspezifische) Daten in dem Datenempfänger 110 (z.B. Basisstation) gespeichert werden.

Bei Ausführungsbeispielen können die absichtlichen Änderungen der Signalparameter in der modulierten Primärinformation, d.h. in den Nutzdaten (engl. payload), des Signals 120 oder mittels eines immanenten Parameters übertragen werden und auf Seiten des Datenempfängers 110 aus der modulierten Primärinformation extrahiert werden (z.B. Klartext, CRC, CMAC).

Oftmals wird bei Aussendungen ein Frequenzsprungverfahren angewandt, um eine bessere Störfestigkeit zu erreichen. Somit sendet der Datensender 130 auf verschiedenen Trägerfrequenzen. Sind dem Datenempfänger 110 vorab nicht die Trägerfrequenzen der jeweiligen Aussendung bekannt, kann der Datenempfänger 110 beispielsweise basierend auf einer Schätzung ermitteln, in welchem Subkanal die Übertragung stattgefunden hat. Falls der Kanalabstand zwischen den Subkanälen größer als der maximale Quarzfehler ist, kann dies durch eine Modulo-Operation erreicht werden.

Um die Frequenzdifferenz unter der Berücksichtigung des gewünschten Kanals zu errechnen, kann bei Ausführungsbeispielen der gewollte Kanal bestimmt werden. Hierfür kann die Frequenz mit der Modulo-Operation durch die Kanalbandbreite dividiert werden. Voraussetzung hierfür ist, dass der Kanalabstand größer ist als der Quarzfehler.

Um die Frequenzdifferenz unter der Berücksichtigung der PLL Auflösungsschrittes zu errechnen, kann bei Ausführungsbeispielen der PLL Auflösungsschritt herausgerechnet werden. Hierfür kann die Frequenz mit der Modulo-Operation durch die PLL Schrittbreite dividiert werden.

Um die Zeitdifferenz unter der Berücksichtigung eines Zeitfehlers, der durch den Sender (z.B. Sendechip) im Datensender 130 bedingt ist, zu berechnen, kann bei Ausführungsbeispielen der Zeitpunkt auch Modulo gerechnet werden, z.B. auf Symboldauer oder Subdatenpaketdauer, oder Telegramdauer, oder Timerauflösung, wobei der Rest der Division den gewünschten Zeitfehler ergibt.

Um die Auflösung der Frequenzschätzung zu erhöhen wird typischerweise eine mehrstufige Synchronisation angewandt, hierbei werden mittels (Teil-)Decodierung die übertragenen Daten geschätzt. Diese können im Anschluss mittels Reencodierung für eine verbesserte Frequenzschätzung eingesetzt werden.

Bei Ausführungsbeispielen kann ein Verfahren mit verbesserter Frequenzschätzgenauigkeit verwendet werden. Beispielsweise können decodierte Bits wieder encodiert werden und die Phase/Frequenz (basierend auf den neu encodierten Bits) noch mal genauer geschätzt werden.

### 6. Weitere Ausführungsbeispiele

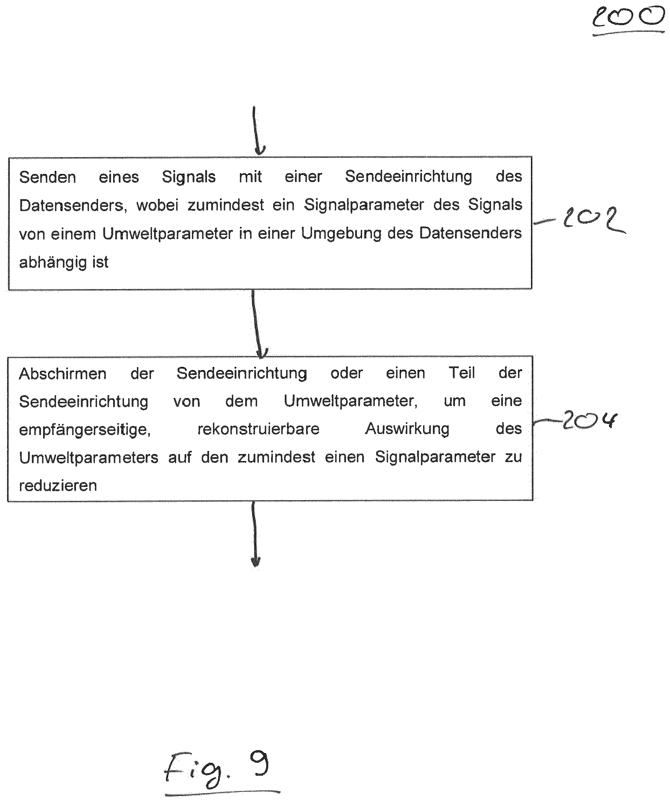

Fig. 9 zeigt ein Flussdiagramm eines Verfahrens 200 zum Betrieb eines Datensenders, gemäß einem Ausführungsbeispiel der vorliegenden Erfindung. Das Verfahren 200 umfasst einen Schritt 202 des Sendens eines Signals mit einer Sendeeinrichtung des Datensenders, wobei zumindest ein Signalparameter des Signals von einem Umweltparameter in einer Umgebung des Datensenders abhängig ist. Ferner umfasst das Verfahren 200 einen Schritt 204 des Abschirmens der Sendeeinrichtung oder eines Teils der Sendeeinrichtung von dem Umweltparameter, um eine empfängerseitige, rekonstruierbare Auswirkung des Umweltparameters auf den zumindest einen Signalparameter zu reduzieren.

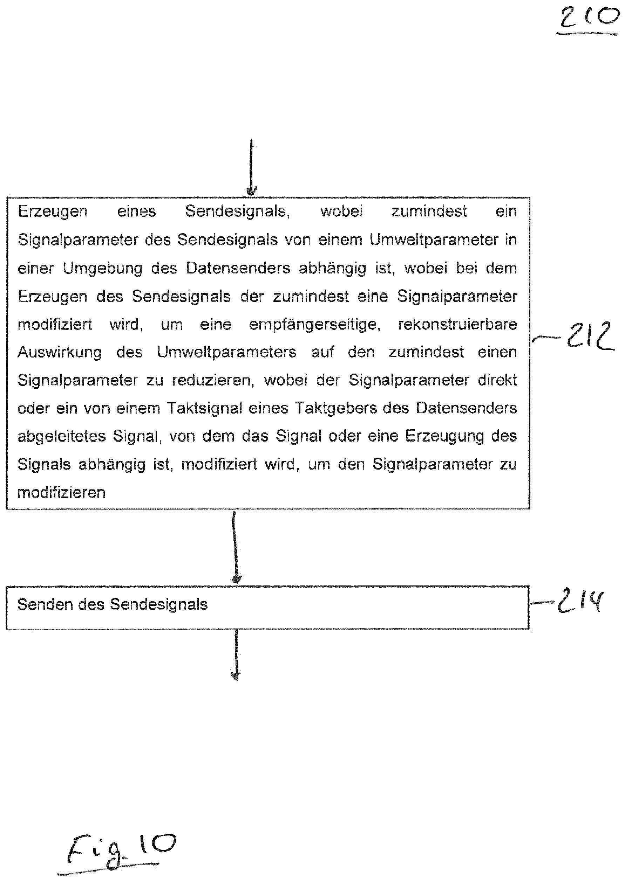

Fig. 10 zeigt ein Flussdiagramm eines Verfahrens 210 zum Senden eines Signals, gemäß einem Ausführungsbeispiel der vorliegenden Erfindung. Das Verfahren 210 umfasst einen Schritt 212 des Erzeugens eines Sendesignals, wobei zumindest ein Signalparameter des Sendesignals von einem Umweltparameter in einer Umgebung des Datensenders abhängig ist, wobei bei dem Erzeugen des Sendesignals der zumindest eine Signalparameter modifiziert wird, um eine empfängerseitige, rekonstruierbare Auswirkung des Umweltparameters auf den zumindest einen Signalparameter zu reduzieren, wobei der Signalparameter direkt oder ein von einem Taktsignal eines Taktgebers des Datensenders abgeleitetes Signal, von dem das Signal oder eine Erzeugung des Signals abhängig ist, modifiziert wird, um den Signalparameter zu modifizieren. Das Verfahren 210 umfasst ferner einen Schritt 214 des Sendens des Sendesignals.

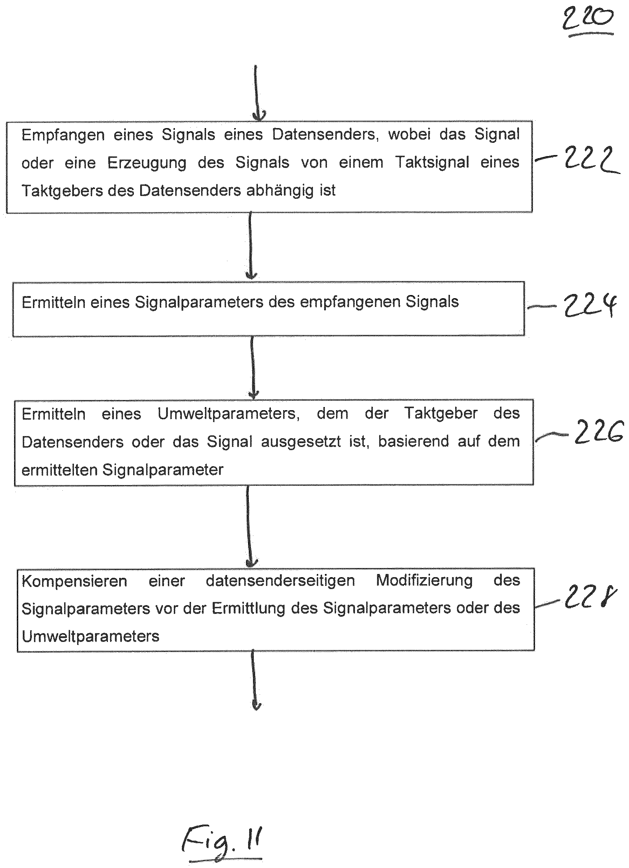

Fig. 11 zeigt ein Flussdiagramm eines Verfahrens 210 zum Ermitteln eines Umweltparameters in der Umgebung eines Datensenders, gemäß einem Ausführungsbeispiel der vorliegenden Erfindung. Das Verfahren 210 umfasst einen Schritt 212 des Empfangens eines Signals eines Datensenders, wobei das Signal oder eine Erzeugung des Signals von einem Taktsignal eines Taktgebers (z.B. eines Frequenzgebers, wie z.B. Oszillators bzw. Quarzes) des Datensenders abhängig ist. Das Verfahren 210 umfasst ferner einen Schritt 214 des Ermitteins (z.B. Schätzens) eines Signalparameters (z.B. einer Signaleigenschaft) des empfangenen Signals. Das Verfahren 210 umfasst ferner einen Schritt 216 des Ermittelns eines Umweltparameters (z.B. eine Temperatur oder Temperaturänderung), dem der Taktgeber des Datensenders oder das Signal ausgesetzt ist, basierend auf dem ermittelten Signalparameter. Das Verfahren 210 umfasst ferner einen Schritt 218 des Kompensierens einer datensenderseitigen Veränderung des Signalparameters vor der Ermittlung des Signalparameters oder des Umweltparameters.

Wie bereits angedeutet, können bei Ausführungsbeispielen Daten unter Verwendung des Telegram-Splitting-Verfahrens (dt. Telegrammaufteilungsverfahrens) zwischen dem Datensender und dem Datenempfänger übertragen werden. Hierbei wird ein Telegramm bzw. Datenpaket in eine Mehrzahl von Sub-Datenpakete (oder Teildatenpakete, oder Teilpakete) aufgeteilt und die Sub-Datenpakete nicht zusammenhängend (engl. discontigously) von dem Datensender zu dem Datenempfänger übertragen, z.B. entsprechend eines Sprungmusters in der Zeit verteilt und/oder in der Frequenz verteilt, wobei der Datenempfänger die Sub-Datenpakete wieder zusammenfügt (oder kombiniert), um das Datenpaket zu erhalten. Jedes der Sub-Datenpakete enthält dabei nur einen Teil des Datenpakets. Das Datenpaket kann ferner kanalcodiert sein, so dass zum fehlerfreien Decodieren des Datenpakets nicht alle Sub-Datenpakete sondern nur ein Teil der Sub-Datenpakete erforderlich ist. Die zeitliche Verteilung der Mehrzahl von Sub-Datenpaketen kann entsprechend eines Zeit- und/oder Frequenzsprungmusters erfolgen.

Weitere Ausführungsbeispiele schaffen einen Datenempfänger, wobei der Datenempfänger ausgebildet ist, um ein Signal eines Datensenders zu empfangen, wobei das Signal oder eine Erzeugung des Signals von einem Taktsignal eines Taktgebers [z.B. eines Frequenzgebers, wie z.B. Oszillators bzw. Quarzes] des Datensenders abhängig ist, wobei der Datenempfänger ausgebildet ist, um einen Signalparameter [z.B. eine Signaleigenschaft] des Signals zu ermitteln [z.B. auszuwerten], und um basierend auf dem Signalparameter einen Umweltparameter [z.B. eine Temperatur oder Temperaturänderung] zu ermitteln [z.B. zu schätzen], dem der Taktgeber des Datensenders oder das Signal ausgesetzt ist.

Bei Ausführungsbeispielen kann der Signalparameter von einem Modulationsinhalt des Signals unabhängig sein.

Bei Ausführungsbeispielen kann das Signal ein digital moduliertes Signal sein, wobei der Datenempfänger ausgebildet sein kann, um einen analogen Signalparameter [z.B. eine analoge Signaleigenschaft] des digital modulierten Signals zu ermitteln.

Beispielsweise kann der Signalparameter von einem Modulationsinhalt des digital modulierten Signals unabhängig sein.

Bei Ausführungsbeispielen kann der Datenempfänger ausgebildet sein, um für die Ermittlung des Signalparameters bekannte Symbole [z.B. Pilotsymbole] in dem Signal zu verwenden.

Bei Ausführungsbeispielen können die bekannten Symbole in Gruppen aufgeteilt sein, wobei sich die Gruppen von Symbolen an verschiedenen Stellen des Signals [z.B. am Anfang und am Ende] befinden können.

Bei Ausführungsbeispielen kann der Datenempfänger ausgebildet sein, um für die Ermittlung des Signalparameters mindestens 4 bekannte Symbole, vorzugsweise 20 bekannte Symbole und besonders vorzugsweise 40 bekannte Symbole zu verwenden.

Bei Ausführungsbeispielen kann das Signal eine Mehrzahl von Sub-Datenpaketen aufweisen, wobei die bekannten Symbole über mehrere Sub-Datenpakete verteilt sind.

Bei Ausführungsbeispielen kann der Datenempfänger ausgebildet sein, um für die Ermittlung des Signalparameters keine bekannten Symbole zu verwenden.

Bei Ausführungsbeispielen kann das Signal neben einer modulierten Primärinformation [z.B. eine ID des Datensenders, eine Synchronisationssequenz, Nutzdaten und/oder Dummy-Daten] eine Information über den Umweltparameter in dem Signalparameter aufweisen.

Bei Ausführungsbeispielen kann das Signal in gewissen Zeitabständen [z.B. gleichen oder ungleichen Zeitabständen] ausgesendet werden, wobei eine Aussendung des Signals oder eine echte Teilmenge der Aussendungen des Signals zusätzlich eine Information über den Umweltparameter [z.B. eine sensorisch bestimmte Version des Umweltparameters] in der modulierten Primärinformation aufweisen kann, wobei der Datenempfänger ausgebildet sein kann, um die Ermittlung [z.B. Schätzung oder Ableitung] des Umweltparameters basierend auf dem Signalparameter basierend auf der in der modulierten Primärinformation enthaltenen Information über den Umweltparameter zu kalibrieren.

Beispielsweise kann der Datenempfänger ausgebildet sein, um das Signal in einer Mehrzahl von Zeitabschnitten einer Abfolge von Zeitabschnitten zu empfangen, wobei das in einer ersten Teilmenge von Zeitabschnitten der Abfolge von Zeitabschnitten empfangene Signal zusätzlich eine Information über den Umweltparameter [z.B. eine sensorisch bestimmte Version des Umweltparameters] in der modulierten Primärinformation aufweist, wobei der Datenempfänger ausgebildet ist, um die Ermittlung [z.B. Schätzung oder Ableitung] des Umweltparameters basierend auf dem Signalparameter basierend auf der in der modulierten Primärinformation enthaltenen Information über den Umweltparameter zu kalibrieren, wobei das in einer zweiten Teilmenge von Zeitabschnitten der Abfolge von Zeitabschnitten empfangene Signal in der modulierten Primärinformation keine Information über den Umweltparameter enthält, wobei die erste Teilmenge von Zeitabschnitten und die zweite Teilmenge von Zeitabschnitten disjunkt sind.

Bei Ausführungsbeispielen kann die modulierte Primärinformation keine Information über den Umweltparameter enthalten.

Bei Ausführungsbeispielen kann der Datenempfänger ausgebildet sein, um den Umweltparameter basierend auf einer Abbildungsfunktion aus dem Signalparameter zu ermitteln.

Bei Ausführungsbeispielen kann dem Datenempfänger die Abbildungsfunktion bekannt sein.

Bei Ausführungsbeispielen kann der Datenempfänger ausgebildet sein, um die Abbildungsfunktion basierend auf zumindest einer von einem Sensor bestimmten Information über den Umweltparameter zu kalibrieren.

Bei Ausführungsbeispielen kann der Datenempfänger ausgebildet sein, um die Abbildungsfunktion basierend auf zumindest zwei von einem Sensor bestimmten Informationen über den Umweltparameter zu ermitteln.

Bei Ausführungsbeispielen kann der Datenempfänger ausgebildet sein, um die Abbildungsfunktion basierend auf einer Polynomapproximation in Abhängigkeit von den zumindest zwei von dem Sensor bestimmten Informationen über den Umweltparameter zu ermitteln.

Bei Ausführungsbeispielen kann der Datenempfänger ausgebildet sein, um die Abbildungsfunktion basierend auf zumindest einer von einem Sensor bestimmten Information über den Umweltparameter aus einem Satz von Abbildungsfunktionen auszuwählen.

Bei Ausführungsbeispielen kann der Datenempfänger ausgebildet sein, um einen Mittelwert und eine Streuung über zumindest zwei von dem Sensor bestimmten Informationen über den Umweltparameter zu ermitteln, wobei der Datenempfänger ausgebildet sein kann, um die Abbildungsfunktion basierend auf dem Mittelwert und der Streuung aus dem Satz von Abbildungsfunktionen auszuwählen.

Bei Ausführungsbeispielen kann das Signal in gewissen Zeitabständen [z.B. gleichen oder ungleichen Zeitabständen] ausgesendet werden, wobei zumindest eine Aussendung des Signals oder eine echte Teilmenge der Aussendungen des Signals [z.B. in der modulierten Primärinformation] die zumindest eine von dem Sensor bestimmte Information über den Umweltparameter aufweist.

Bei Ausführungsbeispielen kann die Abbildungsfunktion eine Temperaturkurve des Taktgebers des Datensenders sein.

Bei Ausführungsbeispielen kann das Signal in gewissen Zeitabständen [z.B. gleichen oder ungleichen Zeitabständen] ausgesendet werden, wobei der Datenempfänger ausgebildet sein kann, um basierend auf zumindest zwei Aussendungen des Signals zumindest zwei Signalparameter zu ermitteln, wobei der Datenempfänger ausgebildet sein kann, um den Umweltparameter basierend auf den zumindest zwei Signalparametern zu ermitteln.

Bei Ausführungsbeispielen kann der Datenempfänger ausgebildet sein, um die zumindest zwei Signalparameter zu kombinieren [z.B. durch Differenzbildung], um ein kombinierten Signalparameter zu erhalten, wobei der Datenempfänger ausgebildet sein kann, um den Umweltparameter basierend auf dem kombinierten Signalparameter zu ermitteln.

Bei Ausführungsbeispielen kann der Datenempfänger ausgebildet sein, um zumindest zwei Signalparameter [z.B. Frequenz und Modulationsfehler] des Signals zu ermitteln, wobei der Datenempfänger ausgebildet sein kann, um basierend auf den zumindest zwei Signalparametern jeweils einen Umweltparameter [z.B. eine Temperatur oder Temperaturänderung] zu ermitteln [z.B. zu schätzen], dem der Taktgeber des Datensenders oder das Signal ausgesetzt ist.

Beispielsweise kann der Datenempfänger basierend auf den zumindest zwei Signalparametern gleiche Umweltparameter [z.B. Temperaturen oder Temperaturdifferenzen] oder unterschiedliche Umweltparameter [z.B. Temperatur und Druck, oder Temperaturdifferenz und Druckdifferenz] ermitteln.

Bei Ausführungsbeispielen kann der Datenempfänger ausgebildet sein, um die ermittelten Umweltparameter zu kombinieren [z.B. durch Mittelwertbildung], um einen kombinierten Umweltparameter zu erhalten.

Bei Ausführungsbeispielen kann das Signal oder eine Erzeugung des Signals ferner von einem weiteren Taktsignal eines weiteren Taktgebers [z.B. Frequenzgeber und Zeitgeber] des Datensenders abhängig sein, wobei der Datenempfänger ausgebildet sein kann, um zwei Signalparameter des Signals zu ermitteln, und um den Umweltparameter basierend auf den zwei Signalparametern zu ermitteln.

Bei Ausführungsbeispielen kann das Signal in gewissen Zeitabständen [z.B. gleichen oder ungleichen Zeitabständen] ausgesendet werden, wobei zumindest eine Aussendung des Signals oder eine echte Teilmenge der Aussendungen des Signals [z.B. in der modulierten Primärinformation] eine Information über eine Abweichung der zwei Taktgeber des Datensenders aufweist, wobei der Datenempfänger ausgebildet sein kann, um die Ermittlung des Umweltparameters basierend auf der Abweichung der zwei Taktgeber des Datensenders zu kalibrieren.

Beispielsweise kann die Abweichung der zwei Taktgeber des Datensenders die aktuelle Differenz der Frequenzen der zwei Taktgeber angegeben. Zum Beispiel können die beiden Taktgeber [z.B. Quarze] gegeneinander vermessen werden, um einen Wert [z.B. in ppm, wie z.B. 20 ppm] festzustellen, der angibt, um wieviel die beiden Taktgeber auseinanderlaufen. Der Wert kann mitgesendet werden. Der Datenempfänger [z.B. Basisstation] kann die Zeit [Empfangszeitpunkt] und Frequenz [Empfangsfrequenz] schätzen und die Information, um die Quarztemperaturkurven des Zeitquarzes oder des Frequenzquarzes am Knoten zu bestimmen/kalibrieren.

Bei Ausführungsbeispielen kann der Datenempfänger ausgebildet sein, um ein weiteres Signal von einem weiteren Datensender zu empfangen, wobei das weitere Signal oder eine Erzeugung des weiteren Signals von einem Taktsignal eines Taktgebers des weiteren Datensenders abhängig ist, wobei der Datensender und der weitere Datensender im Wesentlichen dem gleichem Umweltparameter ausgesetzt sind [z.B. im gleichen Raum angeordnet sind], wobei der Datenempfänger ausgebildet sein kann, um einen weiteren Signalparameter des weiteren Signals zu ermitteln, und um den Umweltparameter basierend auf dem Signalparameter und dem weiteren Signalparameter zu ermitteln.

Bei Ausführungsbeispielen kann der Datenempfänger ausgebildet sein, um den Signalparameter und den weiteren Signalparameter zu kombinieren, um einen kombinierten Signalparameter zu erhalten, und um den Umweltparameter basierend auf dem kombinierten Signalparameter zu ermitteln.

Bei Ausführungsbeispielen können der Signalparameter und der weitere Signalparameter einzeln die Ermittlung eines relativen Umweltparameters [z.B. Temperaturänderungen] ermöglichen, wobei der Datenempfänger ausgebildet sein kann, um basierend auf dem Signalparameter und dem weiteren Signalparameter in Kombination einen absoluten Umweltparameter zu ermitteln.

Bei Ausführungsbeispielen können der Datensender und der weitere Datensender unterschiedlichen Funksystemen angehörig sein [z.B. Datensender unterschiedlicher Funksysteme sind].

Bei Ausführungsbeispielen kann das Taktsignal des Taktgebers von dem Umweltparameter abhängig sein.

Bei Ausführungsbeispielen kann der Datenempfänger ausgebildet sein, um einen altersbedingten Einfluss des Taktgebers auf den Signalparameter zu kompensieren.

Beispielsweise kann dem Datenempfänger der altersbedingte Einfluss des Taktgebers auf den Signalparameter bekannt sein. Ferner oder alternativ kann der Datenempfänger ausgebildet sein, um den altersbedingten Einfluss des Taktgebers auf den Signalparameter zu ermitteln bzw. zu schätzen, z.B. basierend auf zumindest zwei aufeinanderfolgenden empfangen Signalen des Datensenders.

Bei Ausführungsbeispielen kann der Datenempfänger ausgebildet sein, um einen exemplarstreuungsbedingten Einfluss des Taktgebers auf den Signalparameter zu kompensieren.

Bei Ausführungsbeispielen kann der Signalparameter
- eine Empfangsträgerfrequenz,
- ein Empfangszeitpunkt,
- eine Empfangssymbolrate,
- ein Empfangsmodulationsindex,
- eine Dopplerfrequenz,
- ein Signal- zu Rauschverhältnis,
- eine Signalleistung,
- eine Kanalphase,
- eine Kanaldämpfung,
- eine Kanaldispersion und/oder
- eine Polarisationsdrehung
oder eine Änderung derselben bzw. desselben sein.

Bei Ausführungsbeispielen kann der Umweltparameter
- eine Temperatur,
- eine Luftfeuchtigkeit,
- ein Atmosphärendruck,
- eine elektromagnetische Strahlung,
- eine Helligkeit,
- eine Bewegung und/oder
- eine Vibration
oder eine Änderung derselben bzw. desselben ist.

Weitere Ausführungsbeispiele schaffen ein System mit einem Datenempfänger gemäß einem der hierin beschriebenen Ausführungsbeispiele und einem Datensender, wobei der Datensender ausgebildet sein kann, um das Signal zu senden, wobei das Signal oder die Erzeugung des Signals von dem Taktsignal des Taktgebers des Datensenders abhängig ist.

Bei Ausführungsbeispielen kann der Datensender ausgebildet sein, um das Signal in gewissen Zeitabständen [z.B. gleichen oder ungleichen Zeitabständen] zu senden, wobei der Datensender ausgebildet sein kann, um zumindest eine Aussendung des Signals oder eine echte Teilmenge der Aussendungen des Signals mit einer von einem Sensor bestimmten Information über den Umweltparameter zu versehen.

Weitere Ausführungsbeispiele schaffen ein Verfahren. Das Verfahren umfasst einen Schritt des Empfangens eines Signals eines Datensenders, wobei das Signal oder eine Erzeugung des Signals von einem Taktsignal eines Taktgebers [z.B. eines Frequenzgebers, wie z.B. Oszillators bzw. Quarzes] des Datensenders abhängig ist. Das Verfahren umfasst ferner einen Schritt des Ermittelns [z.B. Schätzens] eines Signalparameters [z.B. eine Signaleigenschaft] des empfangenen Signals. Das Verfahren umfasst ferner einen Schritt des Ermittelns eines Umweltparameters [z.B. eine Temperatur oder Temperaturänderung], dem der Taktgeber des Datensenders oder das Signal ausgesetzt ist, basierend auf dem ermittelten Signalparameter.

Bei Ausführungsbeispielen kann ein Einfluss der Umwelt auf den Taktgeber des Datensenders mindestens um den Faktor zwei oder bevorzugt um den Faktor vier größer sein als ein Einfluss der Umwelt auf einen Taktgeber eines Datenempfängers, der das Signal des Datensenders empfängt.

Bei Ausführungsbeispielen kann ein Einfluss der Umwelt auf einen Taktgeber eines Datenempfängers, der das Signals des Datensenders empfängt, mindestens um den Faktor zwei oder bevorzugt um den Faktor vier größer sein als ein Einfluss der Umwelt auf den Taktgeber des Datensenders.

Obwohl manche Aspekte im Zusammenhang mit einer Vorrichtung beschrieben wurden, versteht es sich, dass diese Aspekte auch eine Beschreibung des entsprechenden Verfahrens darstellen, sodass ein Block oder ein Bauelement einer Vorrichtung auch als ein entsprechender Verfahrensschritt oder als ein Merkmal eines Verfahrensschrittes zu verstehen ist. Analog dazu stellen Aspekte, die im Zusammenhang mit einem oder als ein Verfahrensschritt beschrieben wurden, auch eine Beschreibung eines entsprechenden Blocks oder Details oder Merkmals einer entsprechenden Vorrichtung dar. Einige oder alle der Verfahrensschritte können durch einen Hardware-Apparat (oder unter Verwendung eines Hardware-Apparats), wie zum Beispiel einen Mikroprozessor, einen programmierbaren Computer oder eine elektronische Schaltung ausgeführt werden. Bei einigen Ausführungsbeispielen können einige oder mehrere der wichtigsten Verfahrensschritte durch einen solchen Apparat ausgeführt werden.

Je nach bestimmten Implementierungsanforderungen können Ausführungsbeispiele der Erfindung in Hardware oder in Software implementiert sein. Die Implementierung kann unter Verwendung eines digitalen Speichermediums, beispielsweise einer Floppy-Disk, einer DVD, einer Blu-ray Disc, einer CD, eines ROM, eines PROM, eines EPROM, eines EEPROM oder eines FLASH-Speichers, einer Festplatte oder eines anderen magnetischen oder optischen Speichers durchgeführt werden, auf dem elektronisch lesbare Steuersignale gespeichert sind, die mit einem programmierbaren Computersystem derart zusammenwirken können oder zusammenwirken, dass das jeweilige Verfahren durchgeführt wird. Deshalb kann das digitale Speichermedium computerlesbar sein.

Manche Ausführungsbeispiele gemäß der Erfindung umfassen also einen Datenträger, der elektronisch lesbare Steuersignale aufweist, die in der Lage sind, mit einem programmierbaren Computersystem derart zusammenzuwirken, dass eines der hierin beschriebenen Verfahren durchgeführt wird.

Allgemein können Ausführungsbeispiele der vorliegenden Erfindung als Computerprogrammprodukt mit einem Programmcode implementiert sein, wobei der Programmcode dahin gehend wirksam ist, eines der Verfahren durchzuführen, wenn das Computerprogrammprodukt auf einem Computer abläuft.

Der Programmcode kann beispielsweise auch auf einem maschinenlesbaren Träger gespeichert sein.

Andere Ausführungsbeispiele umfassen das Computerprogramm zum Durchführen eines der hierin beschriebenen Verfahren, wobei das Computerprogramm auf einem maschinenlesbaren Träger gespeichert ist.

Mit anderen Worten ist ein Ausführungsbeispiel des erfindungsgemäßen Verfahrens somit ein Computerprogramm, das einen Programmcode zum Durchführen eines der hierin beschriebenen Verfahren aufweist, wenn das Computerprogramm auf einem Computer abläuft.

Ein weiteres Ausführungsbeispiel der erfindungsgemäßen Verfahren ist somit ein Datenträger (oder ein digitales Speichermedium oder ein computerlesbares Medium), auf dem das Computerprogramm zum Durchführen eines der hierin beschriebenen Verfahren aufgezeichnet ist. Der Datenträger, das digitale Speichermedium oder das computerlesbare Medium sind typischerweise gegenständlich und/oder nichtvergänglich bzw. nichtvorübergehend.

Ein weiteres Ausführungsbeispiel des erfindungsgemäßen Verfahrens ist somit ein Datenstrom oder eine Sequenz von Signalen, der bzw. die das Computerprogramm zum Durchführen eines der hierin beschriebenen Verfahren darstellt bzw. darstellen. Der Datenstrom oder die Sequenz von Signalen kann bzw. können beispielsweise dahin gehend konfiguriert sein, über eine Datenkommunikationsverbindung, beispielsweise über das Internet, transferiert zu werden.

Ein weiteres Ausführungsbeispiel umfasst eine Verarbeitungseinrichtung, beispielsweise einen Computer oder ein programmierbares Logikbauelement, die dahin gehend konfiguriert oder angepasst ist, eines der hierin beschriebenen Verfahren durchzuführen.

Ein weiteres Ausführungsbeispiel umfasst einen Computer, auf dem das Computerprogramm zum Durchführen eines der hierin beschriebenen Verfahren installiert ist.

Ein weiteres Ausführungsbeispiel gemäß der Erfindung umfasst eine Vorrichtung oder ein System, die bzw. das ausgelegt ist, um ein Computerprogramm zur Durchführung zumindest eines der hierin beschriebenen Verfahren zu einem Empfänger zu übertragen. Die Übertragung kann beispielsweise elektronisch oder optisch erfolgen. Der Empfänger kann beispielsweise ein Computer, ein Mobilgerät, ein Speichergerät oder eine ähnliche Vorrichtung sein. Die Vorrichtung oder das System kann beispielsweise einen Datei-Server zur Übertragung des Computerprogramms zu dem Empfänger umfassen.

Bei manchen Ausführungsbeispielen kann ein programmierbares Logikbauelement (beispielsweise ein feldprogrammierbares Gatterarray, ein FPGA) dazu verwendet werden, manche oder alle Funktionalitäten der hierin beschriebenen Verfahren durchzuführen. Bei manchen Ausführungsbeispielen kann ein feldprogrammierbares Gatterarray mit einem Mikroprozessor zusammenwirken, um eines der hierin beschriebenen Verfahren durchzuführen. Allgemein werden die Verfahren bei einigen Ausführungsbeispielen seitens einer beliebigen Hardwarevorrichtung durchgeführt. Diese kann eine universell einsetzbare Hardware wie ein Computerprozessor (CPU) sein oder für das Verfahren spezifische Hardware, wie beispielsweise ein ASIC.

Die hierin beschriebenen Vorrichtungen können beispielsweise unter Verwendung eines Hardware-Apparats, oder unter Verwendung eines Computers, oder unter Verwendung einer Kombination eines Hardware-Apparats und eines Computers implementiert werden.

Die hierin beschriebenen Vorrichtungen, oder jedwede Komponenten der hierin beschriebenen Vorrichtungen können zumindest teilweise in Hardware und/oder in Software (Computerprogramm) implementiert sein.

Die hierin beschriebenen Verfahren können beispielsweise unter Verwendung eines Hardware-Apparats, oder unter Verwendung eines Computers, oder unter Verwendung einer Kombination eines Hardware-Apparats und eines Computers implementiert werden.

Die hierin beschriebenen Verfahren, oder jedwede Komponenten der hierin beschriebenen Verfahren können zumindest teilweise durch Hardware und/oder durch Software ausgeführt werden.

Die oben beschriebenen Ausführungsbeispiele stellen lediglich eine Veranschaulichung der Prinzipien der vorliegenden Erfindung dar. Es versteht sich, dass Modifikationen und Variationen der hierin beschriebenen Anordnungen und Einzelheiten anderen Fachleuten einleuchten werden. Deshalb ist beabsichtigt, dass die Erfindung lediglich durch den Schutzumfang der nachstehenden Patentansprüche und nicht durch die spezifischen Einzelheiten, die anhand der Beschreibung und der Erläuterung der Ausführungsbeispiele hierin präsentiert wurden, beschränkt sei.

### Literaturverzeichnis

[1] https://de.wikipedia.org/wiki/Schwingquarz
[2] https://www.nxp.com/docs/en/application-note/AN3251.pdf
[3] https://de.wikipedia.org/wiki/Quadraturphasenumtastung#/media/ File:QPSK_Gray_Coded.svg
[4] http://eur-lex.europa.eu/legalcontent/DE/TXT/PDF/?uri=uriserv:OJ.L_.2016.119.01.0001.01.DEU
[5] https://de.wikipedia.org/wiki/Pierce-Schaltung

## Patentansprüche

1. Datensender (130), mit folgenden Merkmalen:
einer Sendeeinrichtung (136), die ausgebildet ist, um ein Signal (120) zu senden, wobei zumindest ein Signalparameter des Signals (120) von einem Umweltparameter (124) in einer Umgebung des Datensenders (130) abhängig ist, und
einer Abschirmeinrichtung (142), die ausgebildet ist, um die Sendeeinrichtung (136) oder einen Teil der Sendeeinrichtung (136) von dem Umweltparameter (124) abzuschirmen, um eine empfängerseitige, rekonstruierbare Auswirkung des Umweltparameters (124) auf den zumindest einen Signalparameter zu reduzieren.

2. Datensender (130) nach dem vorangehenden Anspruch,
wobei die Sendeeinrichtung (136) einen Taktgeber (134) aufweist,
wobei ein von dem Taktgeber (134) bereitgestelltes Taktsignal (132) von dem Umweltparameter (124) in der Umgebung des Datensenders (130) abhängig ist,
wobei das Signal (120) oder eine Erzeugung des Signals (120) von dem Taktsignal (132) des Taktgebers (134) abhängig ist,
wobei die Abschirmeinrichtung (142) ausgebildet ist, um die Sendeeinrichtung (136) oder den Taktgeber (134) der Sendeeinrichtung (136) von dem Umweltparameter (124) abzuschirmen.

3. Datensender (130) nach einem der vorangehenden Ansprüche,
wobei der Umweltparameter (124) eine Umgebungstemperatur ist,
wobei die Abschirmeinrichtung (142) ausgebildet ist, um die Sendeeinrichtung (136) von der Umgebungstemperatur thermisch abzuschirmen.

4. Datensender (130) nach einem der vorangehenden Ansprüche,
wobei der Umweltparameter (124) eine Umgebungstemperatur ist,
wobei die Abschirmeinrichtung (142) ausgebildet ist, um eine thermische Trägheit zwischen der Umgebungstemperatur und der Sendeeinrichtung (136) zu erhöhen.

5. Datensender (130) nach einem der vorangehenden Ansprüche,
wobei die Abschirmeinrichtung (142) einen Kühlkörper aufweist, der mit der Sendeeinrichtung (136) thermisch gekoppelt ist.

6. Datensender (130) nach einem der vorangehenden Ansprüche,
wobei die Abschirmeinrichtung (142) ausgebildet ist, um die Sendeeinrichtung (136) zu kühlen.

7. Datensender (130) nach einem der vorangehenden Ansprüche,
wobei die Abschirmeinrichtung (142) ausgebildet ist, um die Sendeeinrichtung (136) zu heizen.

8. Datensender (130) nach einem der vorangehenden Ansprüche,
wobei die Abschirmeinrichtung (142) ausgebildet ist, um die Sendeeinrichtung (136) oder einen Taktgeber (134) der Sendeeinrichtung (136) mit einem Microcontroller des Datensenders (130) thermisch zu koppeln, um eine Temperatur der Sendeeinrichtung (136) oder des Taktgebers zu beeinflussen.

9. Datensender (130) nach Anspruch 8,
wobei der Datensender (130) ausgebildet ist, um den Mikrocontroller zu zufälligen oder pseudo-zufälligen Zeitpunkten zu aktivieren, um eine Temperatur der Sendeeinrichtung (136) oder des Taktgebers zu beeinflussen, und/oder
wobei der Datensender (130) ausgebildet ist, um den Mikrocontroller für eine zufällige oder pseudo-zufällige Zeit aktiviert zu lassen, um eine Temperatur der Sendeeinrichtung (136) oder des Taktgebers zu beeinflussen.

10. Datensender (130) nach einem der vorangehenden Ansprüche,
wobei die Abschirmeinrichtung (142) ausgebildet ist, um den Einfluss des Umweltparameters auf den Signalparameter um zumindest den Faktor 5 zu reduzieren.

11. Datensender (130) nach einem der vorangehenden Ansprüche,
wobei der Signalparameter des Signals
- eine Trägerfrequenz,
- ein Sendezeitpunkt,
- eine Symbolrate,
- ein Modulationsindex, oder
- eine Signalleistung
oder eine Änderung derselben bzw. desselben ist.

12. Datensender (130) nach einem der vorangehenden Ansprüche,
wobei der Umweltparameter (124)
- eine Temperatur,
- eine Luftfeuchtigkeit,
- ein Atmosphärendruck,
- eine elektromagnetische Strahlung,
- eine Helligkeit,
- eine Bewegung und/oder
- eine Vibration
oder eine Änderung derselben bzw. desselben ist.

13. Datensender (130) nach einem der vorangehenden Ansprüche,
wobei der Datensender (130) eine Einrichtung zum Modifizieren des Signalparameters aufweist, die ausgebildet ist, um den zumindest einen Signalparameter zu modifizieren, um eine empfängerseitige, rekonstruierbare Auswirkung des Umweltparameters auf den zumindest einen Signalparameter zu reduzieren,
wobei die Einrichtung zum Modifizieren des Signalparameters ausgebildet ist, um den zumindest einen Signalparameter direkt oder ein von einem Taktsignal (132) eines Taktgebers des Datensenders (130) abgeleitetes Signal, von dem das Signal oder eine Erzeugung des Signals abhängig ist, zu modifizieren, um den zumindest einen Signalparameter zu modifizieren.

14. Datensender (130), mit folgenden Merkmalen:
einer Sendeeinrichtung, die ausgebildet ist, um ein Signal zu senden, wobei zumindest ein Signalparameter des Signals von einem Umweltparameter (124) in einer Umgebung des Datensenders (130) abhängig ist, und
einer Einrichtung zum Modifizieren des Signalparameters aufweist, die ausgebildet ist, um den zumindest einen Signalparameter zu modifizieren, um eine empfängerseitige, rekonstruierbare Auswirkung des Umweltparameters auf den zumindest einen Signalparameter zu reduzieren,
wobei die Einrichtung zum Modifizieren des Signalparameters ausgebildet ist, um den zumindest einen Signalparameter direkt oder ein von einem Taktsignal (132) eines Taktgebers des Datensenders (130) abgeleitetes Signal, von dem das Signal oder eine Erzeugung des Signals abhängig ist, zu modifizieren, um den Signalparameter zu modifizieren.

15. Datensenders (130) nach einem der Ansprüche 13 bis 14,
wobei die Einrichtung zum Modifizieren des Signalparameters ausgebildet ist, um den Signalparameter basierend auf einer Abweichung des Signalparameters von einem Sollwert zu modifizieren.

16. Datensenders (130) nach einem der Ansprüche 13 bis 15,
wobei ein von dem Taktgeber (134) bereitgestelltes Taktsignal (132) von dem Umweltparameter (124) in der Umgebung des Datensenders (130) abhängig ist,
wobei das Signal oder eine Erzeugung des Signals von dem Taktsignal (132) des Taktgebers abhängig ist.

17. Datensenders (130) nach Anspruch 16,
wobei die Einrichtung zum Modifizieren des Signalparameters ausgebildet ist, um eine Abweichung eines Taktsignalparameters des Taktsignals (132) von einem Sollwert zu ermitteln,
wobei die Einrichtung zum Modifizieren des Signalparameters ausgebildet ist, um den Signalparameter des Signals basierend auf der ermittelten Abweichung des Taktsignalparameters zu modifizieren.

18. Datensenders (130) nach einem der Ansprüche 13 bis 17,
wobei die Einrichtung zum Modifizieren des Signalparameters ausgebildet ist, um den Signalparameter des Signals in Abhängigkeit von dem Umweltparameter (124) in der Umgebung des Datensenders (130) zu modifizieren.

19. Datensenders (130) nach Anspruch 18,
wobei der Datensenders (130) ausgebildet ist, um den Umweltparameter (124) in der Umgebung des Datensenders (130) zu ermitteln.

20. Datensenders (130) nach Anspruch 18,
wobei der Datensenders (130) ausgebildet ist, um ein Signal von einem anderen Datensenders (130) zu empfangen,
wobei das empfangene Signal eine Information über den Umweltparameter (124) in der Umgebung des Datensenders (130) aufweist oder wobei der Datensenders (130) ausgebildet ist, um basierend auf einem Signalparameter des empfangenen Signals den Umweltparameter (124) in der Umgebung des Datensenders (130) zu schätzen.

21. Datensenders (130) nach einem der Ansprüche 13 bis 20,
wobei die Einrichtung zum Modifizieren des Signalparameters ausgebildet ist, um einen Taktteiler des Taktsignals, der zur Erzeugung des Signals verwendet wird, basierend auf dem Umweltparameter (124) in der Umgebung des Datensenders (130) zu verändern, um den Signalparameter des Signals zu modifizieren, wobei der Taktteiler kein Teil des Taktgebers ist.

22. Datensenders (130) nach einem der Ansprüche 13 bis 21,
wobei die Einrichtung zum Modifizieren des Signalparameters ausgebildet ist, um einen einstellbaren Kondensator, der zur Erzeugung des Signals verwendet wird, basierend auf dem Umweltparameter (124) in der Umgebung des Datensenders (130) einzustellen, um den Signalparameter des Signals zu modifizieren, wobei der Kondensator kein Teil des Taktgebers ist.

23. Datensenders (130) nach einem der Ansprüche 13 bis 22,
wobei die Einrichtung zum Modifizieren des Signalparameters ausgebildet ist, um Korrekturwerte für den Signalparameter an die Sendeeinrichtung (136) auszugeben, um den Signalparameter des Signals zu modifizieren.

24. Datensenders (130) nach einem der Ansprüche 13 bis 23,
wobei der Signalparameter des Signals
- eine Trägerfrequenz,
- ein Sendezeitpunkt,
- eine Symbolrate,
- ein Modulationsindex, oder
- eine Signalleistung
oder eine Änderung derselben bzw. desselben ist.

25. Datensenders (130) nach einem der Ansprüche 13 bis 24,
wobei der Umweltparameter (124)
- eine Temperatur,
- eine Luftfeuchtigkeit,
- ein Atmosphärendruck,
- eine elektromagnetische Strahlung,
- eine Helligkeit,
- eine Bewegung und/oder
- eine Vibration
oder eine Änderung derselben bzw. desselben ist.

26. Datenempfänger (110),
wobei der Datenempfänger (110) ausgebildet ist, um ein Signal (120) eines Datensenders (130) zu empfangen, wobei das Signal (120) oder eine Erzeugung des Signals (120) von einem Taktsignal (132) eines Taktgebers (134) des Datensenders (130) abhängig ist,
wobei der Datenempfänger (110) ausgebildet ist, um einen Signalparameter (112) des Signals (120) zu ermitteln, und um basierend auf dem Signalparameter (112) einen Umweltparameter (114) zu ermitteln, dem der Taktgeber (134) des Datensenders (130) oder das Signal (120) ausgesetzt ist,
wobei der Datensender (130) ausgebildet ist, um eine datensenderseitige Modifizierung des Signalparameters vor der Schätzung des Signalparameters oder des Umweltparameters zu kompensieren.

27. Datenempfänger nach Anspruch 26,
wobei dem Datenempfänger die datensenderseitige Modifizierung des Signalparameters bekannt ist.

28. Datenempfänger nach Anspruch 26,
wobei der Datenempfänger ausgebildet ist, um die datensenderseitige Modifizierung des Signalparameters von einem immanenten Parameter des Kommunikationssystems des Datenempfängers oder einer mit dem Signal übertragenen Nachricht abzuleiten.

29. Datenempfänger nach Anspruch 26,
wobei der Datenempfänger ausgebildet ist, um die datensenderseitige Modifizierung des Signalparameters von einem dem Datensender und dem Datenempfänger bekannten kryptografischen Schlüssel oder Schlüsselpaar abzuleiten.

30. System, mit folgenden Merkmalen:
einem Datensenders (130) nach einem der Ansprüche 1 bis 25, und
einem Datenempfänger nach einem der Ansprüche 26 bis 29.

31. Verfahren, mit folgenden Schritten:
Senden eines Signals mit einer Sendeeinrichtung (136) des Datensenders (130), wobei zumindest ein Signalparameter des Signals von einem Umweltparameter (124) in einer Umgebung des Datensenders (130) abhängig ist,
Abschirmen der Sendeeinrichtung (136) oder einen Teil der Sendeeinrichtung (136) von dem Umweltparameter, um eine empfängerseitige, rekonstruierbare Auswirkung des Umweltparameters auf den zumindest einen Signalparameter zu reduzieren.

32. Verfahren zum Betrieb eines Datensenders, mit folgenden Schritten:
Erzeugen eines Sendesignals, wobei zumindest ein Signalparameter des Sendesignals von einem Umweltparameter (124) in einer Umgebung des Datensenders abhängig ist, wobei bei dem Erzeugen des Sendesignals der zumindest eine Signalparameter modifiziert wird, um eine empfängerseitige, rekonstruierbare Auswirkung des Umweltparameters auf den zumindest einen Signalparameter zu reduzieren, wobei der Signalparameter direkt oder ein von einem Taktsignal (132) eines Taktgebers des Datensenders abgeleitetes Signal, von dem das Signal oder eine Erzeugung des Signals abhängig ist, modifiziert wird, um den Signalparameter zu modifizieren und
Senden des Sendesignals.

33. Verfahren, mit folgenden Schritten:
Empfangen eines Signals (120) eines Datensenders (130), wobei das Signal (120) oder eine Erzeugung des Signals (120) von einem Taktsignal (132) eines Taktgebers (134) des Datensenders (130) abhängig ist,
Ermitteln eines Signalparameters (112) des empfangenen Signals,
Ermitteln eines Umweltparameters, dem der Taktgeber (134) des Datensenders (130) oder das Signal (120) ausgesetzt ist, basierend auf dem ermittelten Signalparameter, und
Kompensieren einer datensenderseitigen Modifizierung des Signalparameters vor der Ermittlung des Signalparameters oder des Umweltparameters.

34. Computerprogramm zur Durchführung des Verfahrens gemäß einem der Ansprüche 31 bis 33, wenn das Computerprogramm auf einem Computer oder Mikroprozessor abläuft.
